(19) **Europäisches Patentamt / European Patent Office / Office européen des brevets**

(11) **EP 4 357 801 B1**

(12) **FASCICULE DE BREVET EUROPEEN**

(45) Date de publication et mention
de la délivrance du brevet:
**26.02.2025 Bulletin 2025/09**

(21) Numéro de dépôt: **23203713.5**

(22) Date de dépôt: **16.10.2023**

(51) Classification Internationale des Brevets (IPC):
**G01R 33/028** (2006.01)    **B06B 1/02** (2006.01)
**B06B 1/04** (2006.01)    **B06B 1/06** (2006.01)

(52) Classification Coopérative des Brevets (CPC):
**G01R 33/0286; B06B 1/0215; B06B 1/04; B06B 1/06**

(54) **DISPOSITIF DE DETECTION D'UN CHAMP MAGNETIQUE ET SYSTEME DE MESURE D'UN CHAMP MAGNETIQUE COMPRENANT UN TEL DISPOSITIF**

MAGNETFELD-ERFASSUNGSVORRICHTUNG UND MAGNETFELD-MESSSYSTEM MIT EINER SOLCHEN VORRICHTUNG

DEVICE FOR DETECTING A MAGNETIC FIELD AND SYSTEM FOR MEASURING A MAGNETIC FIELD COMPRISING SUCH A DEVICE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **21.10.2022 FR 2210915**

(43) Date de publication de la demande:
**24.04.2024 Bulletin 2024/17**

(73) Titulaire: **Commissariat à l'Energie Atomique et aux Energies Alternatives**
**75015 Paris (FR)**

(72) Inventeur: **NIKOLOVSKI, Jean-Pierre**
**38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(56) Documents cités:
**GB-A- 2 540 477    US-A- 5 159 838**
**US-A- 5 966 008**

• **VOLOVIK V D ET AL: "ELECTROACOUSTIC MAGNETOMETER", INSTRUMENTS AND EXPERIMENTAL TECHNIQUES, CONSULTANTS BUREAU. NEW YORK, US, vol. 26, no. 4, 1 July 1983 (1983-07-01), pages 955 - 956, XP001424990, ISSN: 0020-4412**

**Description**

La présente demande de brevet revendique la priorité de la demande de brevet français FR22/10915.

Domaine technique

La présente description concerne de façon générale la mesure de champ magnétique statique ou variable dans le temps.

Technique antérieure

Pour certaines applications, il serait souhaitable de pouvoir mesurer un champ magnétique statique ou variable dans le temps avec une résolution spatiale inférieure à 0,1 mm. En outre, pour certaines applications, il serait souhaitable de pouvoir mesurer un champ magnétique variable dans le temps, notamment un champ magnétique impulsionnel ou à haute fréquence. De plus, pour certaines applications, il serait souhaitable de pouvoir mesurer avec un même dispositif un champ magnétique de faible intensité ou de forte intensité.

Un exemple de dispositif de détection d'un champ magnétique disponible dans le commerce est un capteur à effet Hall. Toutefois, un tel capteur a de façon générale une précision spatiale supérieure à 0,1 mm et n'est donc pas adapté à la mesure d'un champ magnétique très localisé. De plus, les capteurs à effet Hall existants ont une bande passante limitée qui ne dépasse pas 100 kHz et ne sont donc pas adaptés à la mesure d'un champ magnétique à haute fréquence. En outre, les capteurs à effet Hall existants ne peuvent pas être commandés de façon synchrone avec une source d'impulsions magnétiques et ne sont donc pas adaptés à la mesure d'un champ magnétique impulsionnel.

Le document US 5 966 008 A divulgue un dispositif de détection d'un champ magnétique comprenant, en particulier, un guide d'ondes acoustiques et un transducteur électroacoustique.

Résumé de l'invention

Un mode de réalisation pallie tout ou partie des inconvénients des dispositif connus de détection de champ magnétique et les systèmes de mesure de champ magnétique comprenant de tels dispositifs.

Un objet d'un mode de réalisation est que le dispositif de détection de champ magnétique permette la mesure d'un champ magnétique statique ou variable dans le temps avec une résolution spatiale inférieure à 0,2 mm.

Un objet d'un mode de réalisation est que le dispositif de détection de champ magnétique permette la mesure d'une impulsion magnétique.

Un objet d'un mode de réalisation est que le dispositif de détection de champ magnétique puisse être fabriqué à coût réduit.

Un mode de réalisation prévoit un dispositif de détection d'un champ magnétique comprenant :

- un premier guide d'ondes acoustiques fuselé ayant une première base et une première extrémité effilée ;
- un premier fil conducteur électriquement rigidement couplé à la première extrémité effilée ; et
- un transducteur électroacoustique rigidement couplé à la première base.

Selon un mode de réalisation, le premier guide d'ondes acoustiques fuselé s'étend selon un axe de la première base vers la première extrémité effilée, la section droite du premier guide d'ondes acoustiques fuselé diminuant depuis la première base jusqu'à la première extrémité effilée, et le premier fil conducteur électriquement comprend une portion orthogonale audit axe au niveau de la première extrémité effilée.

Selon un mode de réalisation, le transducteur électroacoustique est un transducteur électroacoustique à ondes transversales polarisées perpendiculairement au plan défini par l'axe du premier guide d'ondes acoustiques fuselé et la tangente au premier fil conducteur électriquement lorsqu'il est orthogonal à l'axe au niveau de la première extrémité effilée et qui se propagent dans la direction première base-première extrémité effilée.

Selon un mode de réalisation, le premier guide d'ondes acoustiques fuselé a la forme d'un cône ou d'un tronc de cône.

Selon un mode de réalisation, le premier guide d'ondes acoustiques fuselé a un angle au sommet inférieur à 15 °.

Selon un mode de réalisation, le premier guide d'ondes acoustiques fuselé a la forme d'un tronc de cône, la première extrémité effilée comprenant une surface plane.

Selon un mode de réalisation, la surface plane a un diamètre inférieur ou égal à une demi-longueur d'onde de la vitesse de phase des ondes de flexion dans la première extrémité effilée.

Selon un mode de réalisation, la surface plane a un rayon inférieur à 1 mm.

Selon un mode de réalisation, le premier guide d'ondes acoustiques fuselé comprend une encoche dans la surface plane recevant le premier fil conducteur électriquement.

Selon un mode de réalisation, le premier guide d'ondes acoustiques fuselé a la forme d'un prisme à base triangulaire.

Selon un mode de réalisation, le premier fil conducteur électriquement comprend une piste conductrice électriquement déposée sur le premier guide d'ondes acoustiques fuselé.

Selon un mode de réalisation, le premier fil conducteur électriquement comprend une lame conductrice électriquement s'étendant le long d'un flanc du premier guide d'ondes acoustiques fuselé à distance dudit flanc et connectée à la première extrémité effilée.

Selon un mode de réalisation, le transducteur électroacoustique est un transducteur piézoélectrique à ondes transversales ou un transducteur électromagnétique à ondes transversales.

Selon un mode de réalisation, le premier guide d'ondes acoustiques fuselé est en un matériau non magnétique.

Selon un mode de réalisation, le premier guide d'ondes acoustiques fuselé est en un matériau choisi dans le groupe comprenant le verre, le silicium, la céramique, les métaux non magnétiques, l'acier austénitique et les alliages de métaux non magnétiques.

Selon un mode de réalisation, la température de fusion du premier guide d'ondes acoustiques fuselé et la température de fusion du premier fil conducteur électriquement sont supérieures à 1000°C.

Selon un mode de réalisation, le dispositif comprend un support en un matériau isolant électriquement entourant le premier guide d'ondes acoustiques fuselé à mi-chemin entre la première base et la première extrémité effilée.

Selon un mode de réalisation, le dispositif comprend une jupe conductrice électriquement entourant le premier guide d'ondes acoustiques fuselé, à distance du guide d'ondes acoustiques fuselé, et comprenant une ouverture pour le passage de la première extrémité effilée.

Selon un mode de réalisation, le transducteur électroacoustique comprend un deuxième guide d'ondes acoustiques fuselé comprenant une deuxième base et une deuxième extrémité effilée, un deuxième fil conducteur électriquement rigidement couplé à la deuxième extrémité effilée, et un premier aimant permanent en face de la deuxième extrémité effilée.

Selon un mode de réalisation, le premier guide d'ondes acoustiques fuselé et le deuxième guide d'ondes acoustiques fuselé forment une pièce monobloc.

Selon un mode de réalisation, le dispositif comprend en outre un troisième guide d'ondes acoustiques fuselé couplé rigidement au premier guide d'ondes acoustiques fuselé, le troisième guide d'ondes acoustiques fuselé comprenant une troisième base et une troisième extrémité effilée, un troisième fil conducteur électriquement rigidement couplé à la troisième extrémité effilée, et un deuxième aimant permanent en face de la troisième extrémité effilée, le transducteur électroacoustique étant situé entre la première base et la troisième base.

Selon un mode de réalisation, le transducteur électroacoustique comprend deux plaquettes piézoélectriques situées en vis-à-vis et fonctionnant en opposition de phase.

Un mode de réalisation prévoit également un système de mesure d'un champ magnétique comprenant un dispositif de détection d'un champ magnétique tel que défini précédemment, et un dispositif de commande et d'acquisition relié au dispositif de détection d'un champ magnétique comprenant un générateur configuré pour fournir au moins une impulsion de courant dans le premier fil conducteur électriquement et une chaîne d'acquisition pour la détection d'un signal électrique fourni par le transducteur électroacoustique ou un générateur configuré pour fournir au moins une impulsion de tension commandant le transducteur électroacoustique et une chaîne d'acquisition pour la détection d'un signal électrique fourni par le premier fil conducteur électriquement.

Selon un mode de réalisation, le champ magnétique correspond à une impulsion magnétique et le dispositif de commande et d'acquisition est configuré pour que le générateur fournisse une impulsion de courant dans le premier fil conducteur électriquement synchrone avec l'impulsion magnétique.

Selon un mode de réalisation, le dispositif de commande et d'acquisition comprend un module de commande du générateur configuré pour recevoir un signal binaire de synchronisation et un signal représentatif d'un délai et pour commander le générateur pour la fourniture de l'impulsion de courant ou de l'impulsion de tension à la fin du délai après la réception du signal de synchronisation.

Selon un mode de réalisation, le générateur est configuré pour fournir l'impulsion de courant ayant une durée deux fois plus courte que la période correspondant à la fréquence de variation maximale du champ magnétique.

Selon un mode de réalisation, le dispositif de commande et d'acquisition comprend un amplificateur recevant le signal de mesure dont le gain est programmable par paliers croissants, chaque palier correspondant à une plage de variation possible de l'amplitude du champ magnétique à mesurer.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe, partielle et schématique, d'un mode de réalisation d'un système de détection de champ magnétique ;

la figure 2, la figure 3, la figure 4, la figure 5, la figure 6, et la figure 7 sont des vues en coupe, partielles et schématiques, d'autres modes de réalisation de la sonde du système de détection ;

la figure 8 et la figure 9 sont des schémas par blocs du système de détection de la figure 1 illustrant des modes de réalisation du dispositif de commande et d'acquisition du système de détection ;

la figure 10 est une vue en coupe, partielle et schématique, d'un mode de réalisation d'un transducteur de la sonde du système de détection de champ magnétique ;

la figure 11 est une vue en coupe, partielle et schématique, d'une variante de réalisation de la sonde 20 représentée en figure 10 ;

la figure 12 est une vue de dessus, partielle et schématique, d'un autre mode de réalisation d'un système de détection de champ magnétique ;

la figure 13 est une vue de côté, partielle et schématique, de la sonde du système de détection de champ magnétique de la figure 12 ;

la figure 14 est une vue de dessus, partielle et schématique, d'une variante de la sonde représentée en figure 12 ;

la figure 15 est une vue de dessus, partielle et schématique, d'une variante de réalisation de la sonde et du transducteur électroacoustique du système de détection de champ magnétique représenté en figure 12 ;

la figure 16 est une vue de dessus, partielle et schématique, d'une variante de réalisation de la sonde et du transducteur électroacoustique du système de détection de champ magnétique représenté en figure 12 ;

la figure 17 est une vue de dessus, partielle et schématique, d'un autre mode de réalisation d'un système de détection de champ magnétique ;

la figure 18 est une vue de côté, partielle et schématique, de la sonde du système de détection de champ magnétique de la figure 17 ;

la figure 19 est une vue de dessus, partielle et schématique, d'un autre mode de réalisation d'un système de détection de champ magnétique ;

la figure 20 est une vue de côté, partielle et schématique, de la sonde du système de détection de champ magnétique de la figure 19 ; et

la figure 21, la figure 22, la figure 23, la figure 24, la figure 25, et la figure 26 représentent des courbes d'évolution en fonction du temps du signal de mesure fourni par le système de détection de champ magnétique obtenues au cours d'essais.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à une sonde dans une position normale d'utilisation.

Sauf précision contraire, les expressions "environ", "approximativement", "sensiblement", et "de l'ordre de" signifient à 10 % près, de préférence à 5 % près. Dans le cas d'angle, les expressions "environ", "approximativement", "sensiblement", et "de l'ordre de" signifient à 10 ° près, de préférence à 5 ° près. En outre, on considère ici que les termes "isolant" et "conducteur" signifient respectivement "isolant électriquement" et "conducteur électriquement".

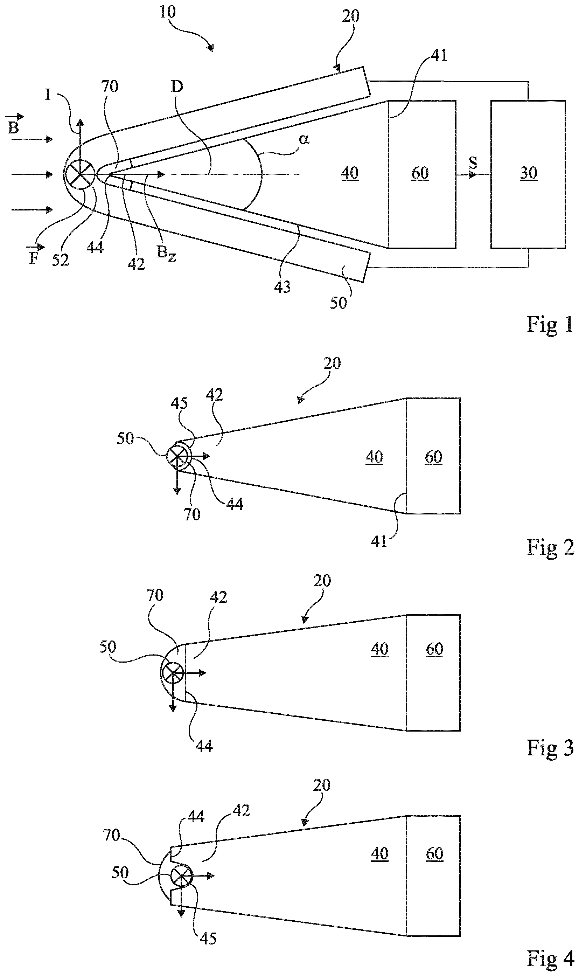

La figure 1 est une vue en coupe, partielle et schématique, d'un mode de réalisation d'un système 10 de détection d'une composante $B_z$ d'un champ magnétique B.

Le système 10 comprend un dispositif 20 de détection de champ magnétique, appelé sonde par la suite, et un dispositif de commande et d'acquisition 30 relié à la sonde 20. La sonde 20 comprend un guide d'ondes acoustiques 40, un fil conducteur électriquement 50, et un transducteur électroacoustique 60.

Le guide d'ondes acoustiques 40 a une forme fuselée selon un axe D avec une section droite dont la surface diminue depuis une base 41 jusqu'à une extrémité effilée 42, appelée pointe par la suite, opposée à la base 41. Le guide d'ondes acoustiques 40 est appelé guide fuselé 40 par la suite. Le fil conducteur 50 s'étend le long de la paroi latérale 43 du guide fuselé 40 jusqu'à la pointe 42. Selon un mode de réalisation, le fil conducteur 50 est replié sur la pointe 42 et fixé à la pointe 42 par un matériau de collage 70.

Selon un mode de réalisation, le guide fuselé 40 a une forme générale de cône ou de cône tronqué. De préférence, le guide fuselé 40 présente une symétrie de révolution autour de l'axe D. Selon un autre mode de réalisation, le guide fuselé 40 a une forme générale prismatique, notamment à base triangulaire. Au moins dans un plan contenant l'axe D, le guide fuselé 40 a une section droite triangulaire d'angle au sommet $\alpha$ inférieur à 15 °, de préférence inférieur à 10 °, plus préférentiellement inférieur à 5 °. Lorsque le guide fuselé 40 a une forme générale de cône ou de cône tronqué, l'angle au sommet $\alpha$ correspond à l'angle au somment du cône. Lorsque le guide fuselé 40 a une forme générale de prisme à base triangulaire, l'angle au sommet $\alpha$ correspond à l'angle au sommet de la base triangulaire du côté de la pointe 42 du guide fuselé 40. Le fil conducteur 50 présente une portion 52 recouvrant la pointe guide fuselé 40 dans laquelle le courant circule sensiblement de façon perpendiculaire à l'axe D du guide fuselé 40.

En fonctionnement, la pointe 42 du guide fuselé 40 est placée à l'endroit où se trouve le champ magnétique B. Le système 10 permet de mesurer la composante $B_z$, selon l'axe D du guide fuselé 40, du champ magnétique $\vec{B}$.

Selon un mode de réalisation, appelé mode de fonctionnement direct par la suite, le dispositif de commande et d'acquisition 30 est configuré pour fournir une impulsion de courant dans le fil conducteur 50. L'impulsion de courant a une intensité I et une durée $\Delta t$. En présence du champ magnétique $\vec{B}$ au niveau de la pointe 42 du guide fuselé 40, il apparaît dans la partie du fil conducteur 50 située à la pointe 42 du guide fuselé 40 une force de Lorentz F dont l'amplitude F est définie par la relation suivante :

[Math 1]

$$F = I\Delta t V B$$

où V est la vitesse des électrons dans le fil conducteur 50.

En mode de fonctionnement direct, le guide fuselé 40 permet de transformer la force de Lorentz F en une onde de flexion ultrasonore impulsionnelle qui reste large bande durant sa propagation dans le guide fuselé 40. L'amplitude de l'onde de flexion ultrasonore est notamment proportionnelle à la composante $B_z$ du champ magnétique $\vec{B}$ à mesurer, à l'intensité I de l'impulsion de courant, et à la durée de $\Delta t$ de l'impulsion de courant. L'onde de flexion est polarisée dans le sens du produit vectoriel $\vec{I} \wedge \vec{B}$ perpendiculairement au plan de la figure 1 défini par l'axe D et la tangente au fil conducteur 50 définissant le vecteur courant $\vec{I}$ là où le fil conducteur 50 est rigidement fixé à l'extrémité de la pointe 42. En raison de sa forme générale effilée avec un faible angle au sommet, le guide fuselé 40 favorise la propagation d'un mode acoustique de flexion engendré à l'extrémité de la pointe 42 jusqu'à la base 41. L'impédance intrinsèque du matériau constituant le guide fuselé 40 est égale au produit de la vitesse fondamentale d'une onde transversale dans le matériau par la densité du matériau. On définit l'impédance mécanique de rayonnement de la pointe 42 du guide fuselé 40 comme le produit de la vitesse de phase d'une onde acoustique à l'endroit du couplage par la densité du matériau constituant le guide fuselé 40. L'impédance mécanique de rayonnement est particulièrement faible, typiquement 3 à 4 fois plus faible que l'impédance intrinsèque du matériau. Cette caractéristique est avantageusement adaptée à un transfert efficace de la force de Lorentz apparaissant dans le fil conducteur 50 rigidement couplé à la pointe 42 par collage. L'onde acoustique atteint le transducteur électroacoustique 60 qui la convertit en un signal électrique S, par exemple une tension. Le dispositif de commande et d'acquisition 30 est configuré pour mesurer le signal électrique S fourni par le transducteur électroacoustique 60 et en déduire l'amplitude de la composante $B_z$ du champ magnétique $\vec{B}$ et la polarisation du champ magnétique $\vec{B}$ présent à la pointe 42 du guide fuselé 40.

Selon un mode de réalisation, l'intensité I de l'impulsion de courant est de préférence aussi élevée que possible, en pratique entre 1 A et 100 A, de préférence environ 50 A. Selon un mode de réalisation, la durée $\Delta t$ de l'impulsion de courant est aussi courte que possible, par exemple entre 1 ns et 500 ns, de préférence environ 10 ns. Dans le cas où le champ magnétique à mesurer correspond à une impulsion magnétique, la durée $\Delta t$ de l'impulsion de courant est inférieure à la durée de l'impulsion magnétique à mesurer. Dans le cas où le champ magnétique à mesurer correspond à un champ magnétique sinusoïdal, la durée $\Delta t$ de l'impulsion de courant est inférieure à au moins deux fois la période du champ magnétique sinusoïdal à mesurer. De façon générale, dans le cas où le champ magnétique à mesurer varie dans le temps, la durée $\Delta t$ de l'impulsion de courant est inférieure à au moins deux fois la période correspondant à la fréquence de variation maximale du champ magnétique.

En mode de fonctionnement direct, le guide fuselé 40 introduit avantageusement un retard de propagation acoustique de 1 $\mu$s à 100 $\mu$s entre l'impulsion électrique présente à la pointe 42 du guide fuselé 40 et la fourniture du signal électrique par le transducteur électroacoustique 60. Ceci permet d'éviter le parasitage d'amplificateur de réception du dispositif de commande et de détection 30 par un couplage aérien direct entre l'impulsion électrique et l'électronique de réception.

Selon un mode de réalisation, appelé mode de fonctionnement réciproque par la suite, le dispositif de commande et d'acquisition 30 est configuré pour commander le transducteur électroacoustique 60 pour la génération d'une onde acoustique dans le guide fuselé 40. En mode de fonctionnement réciproque, le guide fuselé 40 permet de propager l'onde ultrasonore depuis la base 41 jusqu'à la pointe 42. L'onde ultrasonore entraîne une flexion de la pointe 42. Le déplacement de la pointe 42, et donc du fil conducteur 50 dans le champ magnétique $\vec{B}$ entraîne l'apparition d'une force électromotrice FEM dans le fil conducteur 50. La force électromotrice FEM est proportionnelle à la composante $B_z$ du champ magnétique $\vec{B}$ à mesurer. Le dispositif de commande et d'acquisition 30 est configuré pour mesurer la force électromotrice FEM aux extrémités du fil conducteur 50 et à en déduire la composante $B_z$ du champ magnétique $\vec{B}$ et la polarisation du champ magnétique $\vec{B}$ présent à la pointe 42 du guide fuselé 40.

Selon un mode de réalisation, le fil conducteur 50 a une section droite cylindrique. Selon un autre mode de réalisation, le fil conducteur 50 a une section droite qui n'est pas cylindrique. Dans ce cas, le diamètre du fil conducteur 50 est égal au diamètre du disque de même surface que la surface de la section droite du fil conducteur 50. Selon un mode de réalisation, le fil conducteur 50 a un diamètre variant de 10 $\mu$m à 200 $\mu$m, par exemple égal à environ 40 $\mu$m. Selon un mode de réalisation, le fil conducteur 50 comprend un coeur conducteur entouré d'une gaine isolante, par exemple un fil émaillé. Selon un autre mode de réalisation, le fil conducteur 50 correspond à une piste conductrice déposée sur le guide fuselé 40.

Selon un mode de réalisation, la pointe 42 du guide fuselé 40 comprend une surface 44, appelée surface d'appui 44 par la suite, sur laquelle repose la portion 52 du fil conducteur 50.

Selon un mode de réalisation, la surface d'appui 44 est plane et perpendiculaire à l'axe D du guide fuselé 40. Selon un mode de réalisation, la surface d'appui 44 est inscrite dans un disque. On appelle alors diamètre de la surface d'appui 44 le diamètre du disque dans lequel est inscrite la surface d'appui 44. Selon un mode de réalisation, la surface d'appui 44 n'est pas plane. Dans ce cas, on appelle diamètre de la surface d'appui 44 le diamètre du disque dans lequel est inscrite la surface d'appui 44 lorsqu'elle est vue selon l'axe D.

Selon un mode de réalisation, la surface d'appui 44 a un diamètre compris entre le diamètre du fil conducteur 50 et le quintuple du diamètre du fil conducteur 50, par exemple entre le double et le quintuple du diamètre du fil conducteur 50. Selon un mode de réalisation, la surface d'appui 44 a un diamètre compris entre le double et le quintuple du diamètre du fil conducteur 50. Selon un mode de réalisation, la surface d'appui 44 a un diamètre égal au diamètre du fil conducteur 50. Le pourtour de la surface d'appui 44 constitue alors une surface d'appui protégeant le fil conducteur 50. Plus le diamètre du fil conducteur 50 est proche du diamètre de la surface d'appui 44 et moins des effets de propagation dans le voisinage de la pointe 42 se font ressentir. A titre d'exemple, pour un fil conducteur 50 de diamètre égal à 40 $\mu$m, le diamètre de la surface d'appui 44 peut être voisin de 100 $\mu$m.

En outre, pour éviter d'écraser le fil conducteur 50 lors des mesures, une encoche de profondeur égale au diamètre du fil conducteur 50 peut être réalisée dans le plan de la surface d'appui 44 de façon à enterrer le fil conducteur 50 dans la pointe 42.

La figure 2, la figure 3, la figure 4, et la figure 5 sont des vues en coupe, partielles et schématiques, d'autres modes de réalisation de la sonde 20. Le plan de coupe des figures 2 à 5 contient l'axe D du guide fuselé 40 et est perpendiculaire au plan de coupe de la figure 1.

Dans le mode de réalisation illustré en figure 2, le diamètre de la surface d'appui 44 est égal au diamètre du fil conducteur 50, et la surface d'appui 44 comprend une encoche 45 dans laquelle est enfoui le fil conducteur 50. Ce mode de réalisation est adaptée notamment pour les champs magnétiques de faibles amplitudes. Le matériau de collage 70 peut être réparti dans l'encoche 45. La portion 52 du fil conducteur 50 reposant sur la face d'appui 44 s'étend de façon sensiblement rectiligne selon un axe perpendiculaire à l'axe D du guide fuselé 40. De préférence, la longueur de la portion rectiligne 52 du fil conducteur 50 ne dépasse pas une demi-longueur d'onde de la vitesse de phase des ondes transversales, soit typiquement moins de 0,5 mm à 1 MHz et 0,1 mm à 5 MHz. Le mode de réalisation illustré en figure 2 permet la détection du champ magnétique $\vec{B}$ avec la meilleure résolution spatiale par rapport aux modes de réalisation illustrés sur les figures 3 à 5.

Dans le mode de réalisation illustré en figure 3, la surface d'appui 44 est plane et le diamètre de la surface d'appui 44 est égal à environ 3 fois le diamètre du fil conducteur 50. Le fil conducteur 50 est posé à plat sur la surface d'appui 44 et est protégé par le matériau de collage 70.

Dans le mode de réalisation illustré en figure 4, le diamètre de la surface d'appui 44 est égal à environ 3 fois le diamètre du fil conducteur 50 et la surface d'appui 44 comprend une encoche 45 dans laquelle est enfoui le fil conducteur 50.

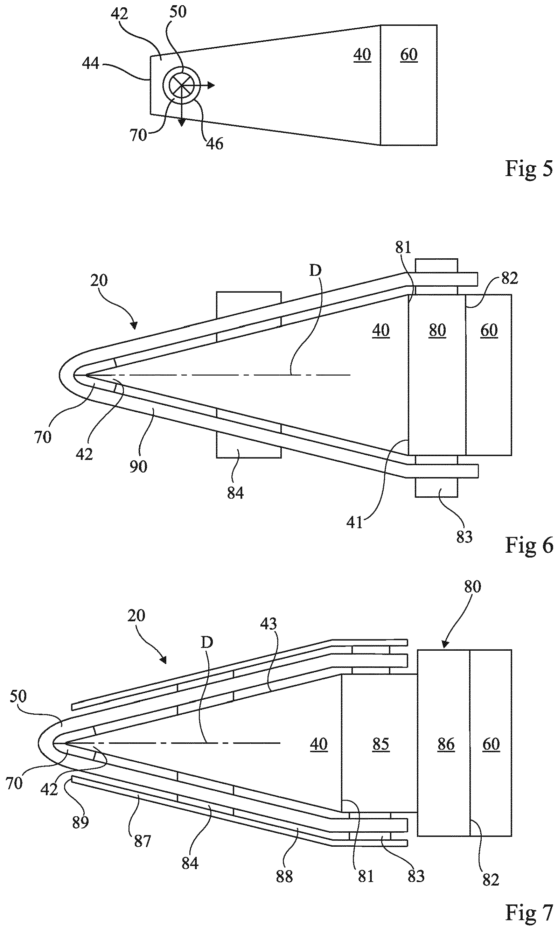

Dans le mode de réalisation illustré en figure 5, le guide fuselé 40 comprend une ouverture traversante 46 dans la pointe 42 à proximité de l'extrémité de la pointe 42, par exemple à une distance de l'extrémité de la pointe 42 variant de une fois à deux fois le diamètre du fil conducteur 50. Le diamètre de l'ouverture traversante 46 est légèrement supérieur au diamètre du fil conducteur 50, et le fil conducteur 50 passe par l'ouverture 46. Le fil conducteur 50 est couplé de façon rigide au guide fuselé 40 par le matériau de collage 70 ou par compression et déformation de l'extrémité de la pointe 42 qui vient légèrement pincer le fil conducteur 50.

Les modes de réalisation illustrés sur les figures 3, 4, et 5 sont avantageusement plus robustes que le mode de réalisation illustré en figure 2. Les modes de réalisation illustrés sur les figures 3, 4, et 5 sont notamment adaptés à des applications pour lesquelles on envisage de pouvoir mettre la sonde 20 en contact avec une surface aimantée. En outre, les risques d'écrasement du fil conducteur 50 dans les modes de réalisation illustrés sur les figures 4 et 5 sont réduits par rapport aux modes de réalisation illustrés sur les figures 2 et 3.

Plus le diamètre de la surface d'appui 44 est grand et moins il y a de perturbation de la mesure lorsque la pointe 42 entre en contact avec une surface dure. En effet, l'impédance de rayonnement de la pointe 42 chute considérablement lorsque l'on se rapproche de l'extrémité de la pointe 42. Son blocage par une surface dure pourrait limiter l'amplitude de l'impulsion mécanique engendrée par la force de Lorentz qui s'applique sur un petit volume de matière, latéralement libre. Cela pourrait fausser la mesure en diminuant l'amplitude du signal. En outre le contact de la pointe 42 avec un milieu solide peut engendrer des ondes ultrasonores dans le milieu qui peuvent revenir dans la pointe 42 et fausser la mesure.

De façon avantageuse, l'encombrement latéral de la pointe 42 de la sonde 20 est au moins dix fois plus faible que l'encombrement latéral des sondes à effet Hall disponibles actuellement dans le commerce.

Selon un mode de réalisation, le fil conducteur 50 comprend au moins un coeur en un matériau conducteur électriquement, éventuellement entouré d'une gaine isolante électriquement. Selon un mode de réalisation, le matériau conducteur est choisi parmi le cuivre, un matériau dont la mobilité électronique est supérieur à 30 cm$^2$/V/s (notamment l'or, l'argent, ou un matériau semiconducteur tel le graphène), ou un mélange d'au moins deux de ces composés. La nature du conducteur composant le fil conducteur 50 est importante que ce soit pour un fonctionnement direct ou réciproque lorsque l'on désire augmenter la sensibilité de la sonde 20 aux champs magnétiques de faibles intensités. Par défaut, on peut utiliser un fil conducteur 50 en cuivre émaillé pour les champs magnétiques allant de quelques milliteslas à plusieurs dizaines de Tesla. Mais pour les applications nécessitant une forte sensibilité aux champs magnétiques de faibles intensités, typiquement lorsqu'ils sont comparables ou inférieurs au millitesla ou au champ magnétique terrestre, on peut faire appel à des matériaux dont la mobilité électronique est plus élevée que celle du cuivre (qui est égale à 30 cm$^2$/V/s), par exemple l'or (43 cm$^2$/V/s), l'argent (68 cm$^2$/V/s) ou des matériaux semiconducteurs tels le graphène. On eut aussi choisir un fil de cuivre recouvert d'une couche de graphène dont la mobilité électronique peut atteindre 200 000 cm$^2$/V/s. La tension électrique qui apparaît aux bornes du fil conducteur 50 en mode réciproque est ainsi augmentée par la plus forte mobilité électronique du matériau constituant le fil conducteur 50 et la sonde 20 produit un signal exploitable et un rapport signal sur bruit amélioré aux champs magnétiques plus faibles par rapport au cas où l'on aurait simplement utilisé un fil conducteur 50 de cuivre émaillé.

Selon un mode de réalisation, le guide fuselé 40 est en un matériau solide non magnétique, notamment un matériau choisi dans le groupe comprenant le verre, le silicium, la céramique, les métaux non magnétiques (notamment l'aluminium, le cuivre, ou le titane), l'acier austénitique et les alliages de métaux non magnétiques, notamment les alliages à base d'aluminium, de cuivre, et/ou de titane.

Le guide fuselé 40 permet, de par sa forme géométrique effilée, de réaliser de façon avantageuse un tampon thermique entre la zone de mesure à la pointe 42 et une zone de réception au niveau du transducteur électroacoustique 60. La zone de mesure peut alors être portée à une température élevée de plusieurs centaines de degrés Celsius tandis que la zone de réception peut être soumise à une température plus basse compatible avec la plage de température tolérée par le transducteur électroacoustique 60.

Le matériau de collage 70 peut être une résine cyanoacrylate, ou une résine époxy, ou une résine polyimide, ou une résine céramique, ou un verre fondu, ou un émail enrobant le fil conducteur 50. Selon un mode de réalisation, le matériau de collage 70 est adapté pour résister aux hautes températures, par exemple jusqu'à 1000°C, ou jusqu'à la plus petite des températures de fusion de la pointe 42 du guide fuselé 40, et la température de fusion du fil conducteur 50. Le matériau de collage 70 correspond par exemple à la colle haute température commercialisée sous l'appellation Ceramabond par la société Aremco.

Dans le mode de fonctionnement direct, le transducteur acoustique 60 est configuré pour recevoir une onde acoustique et fournir un signal électrique analogique, par exemple une tension ou un courant, appelé signal de mesure par la suite. L'amplitude du signal de mesure dépend de l'amplitude de l'onde acoustique, de préférence est proportionnelle à l'amplitude de l'onde acoustique. Dans le mode de fonctionnement direct, le transducteur acoustique 60 reçoit un paquet et fournit un signal électrique de mesure comprenant au moins un pic, et de façon générale plusieurs pics positifs et négatifs. Dans le mode de fonctionnement réciproque, le transducteur acoustique 60 est configuré pour recevoir un signal électrique analogique, par exemple une tension ou un courant, appelé signal de commande par la suite, et fournir une onde acoustique. L'amplitude de l'onde acoustique dépend de l'amplitude du signal de commande, de préférence est proportionnelle à l'amplitude du signal de commande. Le transducteur acoustique 60 peut être un transducteur acoustique à ondes transversales. Selon un mode de réalisation, le transducteur acoustique 60 est un transducteur piézoélectrique ou un transducteur acoustique électromagnétique. Le transducteur 60 correspond par exemple au transducteur piézoélectrique commercialisé par la société Olympus sous l'appellation V153 qui peut présenter une fréquence centrale autour de 1 MHz.

La figure 6 est une vue en coupe, partielle et schématique, d'un autre mode de réalisation de la sonde 20. La sonde 20 représentée sur la figure 6 comprend l'ensemble des éléments de la sonde 20 représentée en figure 1 et comprend, en outre, un guide d'ondes acoustiques droit 80 interposé entre le guide fuselé 40 et le transducteur électroacoustique 60. Le guide d'ondes acoustiques droit 80 a une section droite constante et s'étend de façon rectiligne et est appelé guide droit 80 par la suite. Selon un mode de réalisation, le guide droit 80 s'étend selon l'axe D et comprend deux faces opposées 81 et 82. Le transducteur électroacoustique 60 est fixé à la face 82 du guide droit 80. Selon un mode de réalisation, le guide fuselé 40 et le guide droit 80 sont des pièces distinctes. La base 41 du guide fuselé 40 est alors fixée à la face 81 du guide droit 80. Selon un autre mode de réalisation, le guide fuselé 40 et le guide droit 80 sont fabriqués d'une même pièce. La base 41 du guide fuselé 40 est alors incluse dans la face 81 du guide droit 80. Dans le mode de réalisation illustré en figure 6, le guide droit 80 a une forme cylindrique à base circulaire et la face 81 du guide droit 80 a le même diamètre que la base 41 du guide fuselé 40.

La sonde 20 comprend, en outre, un support 83 du guide fuselé 40 fixé au guide droit 80. Le support 83 est en un matériau isolant électriquement, par exemple en matière plastique, notamment un polymère. Le support 83 permet notamment la manipulation du guide fuselé 40. Le fil conducteur 50 peut être fixé au support 83. La sonde 20 peut comprendre, en outre, un support supplémentaire 84 fixé au guide fuselé 40, par exemple à mi-hauteur du guide fuselé 40 entre la pointe 42 et la base 41. Le fil conducteur 50 peut être fixé au support supplémentaire 84. Le support supplémentaire 84 est en un matériau isolant électriquement, par exemple en matière plastique, notamment un polymère.

La figure 7 est une vue en coupe, partielle et schématique, d'un autre mode de réalisation de la sonde 20. La sonde 20 représentée sur la figure 7 comprend l'ensemble des éléments de la sonde 20 représentée en figure 6 à la différence que le le guide droit 80 comprend deux portions cylindriques successives 85 et 86 à base circulaire de diamètres différents. La face 81 du guide droit 80 a le même diamètre que la base 41 du guide fuselé 40 et la face 82 du guide droit 80 a sensiblement le même diamètre que le transducteur électroacoustique 60. Dans le mode de réalisation illustré en figure 7, la sonde 20 comprend en outre une jupe 87 entourant complétement la paroi latérale 43 du guide fuselé 40. Dans le cas où le guide fuselé 40 a une forme conique, la jupe 87 peut correspondre à un tronc de cône creux. Un interstice 88 est prévu entre la jupe 87 et le guide fuselé 40 de sorte que la jupe 87 n'est pas en contact direct avec le guide fuselé 40. La jupe 87 peut être maintenue par le support 83. La jupe 87 peut être en un matériau métallique. La jupe 87 comprend une ouverture 89 au travers de laquelle émerge la pointe 42 du guide fuselé 40 et la portion 52 du fil conducteur 50 repliée sur la pointe 42. La jupe 87 protège le guide fuselé 40 et constitue un écran de blindage pour les parties du fil conducteur 50 s'étendant le long de la paroi latérale 43 du guide fuselé 40.

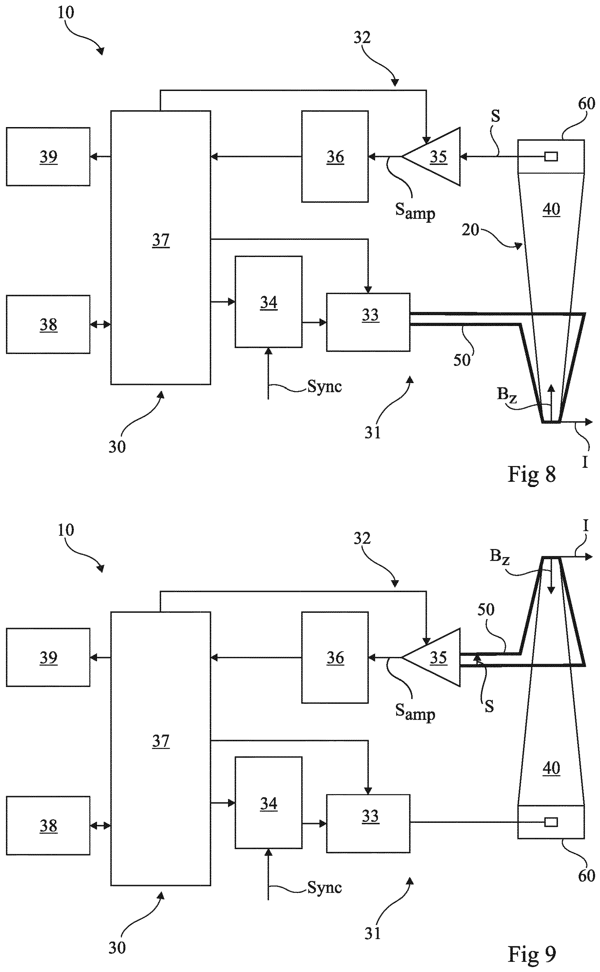

La figure 8 représente un schéma par blocs du système de détection 10 illustrant un mode de réalisation du dispositif de commande et d'acquisition 30 pour la mise en oeuvre du mode de fonctionnement direct. Selon un mode de réalisation, le transducteur électroacoustique 60 est un transducteur piézoélectrique.

Le dispositif de commande et d'acquisition 30 comprend notamment une chaîne de commande 31 et une chaîne d'acquisition 32. La chaîne de commande 31 comprend :

- un générateur 33 d'impulsions de courant dans le fil conducteur 50 relié aux deux extrémités du fil conducteur 50 ; et
- un module de commande 34 du générateur d'impulsions de courant 33 recevant un signal de synchronisation Sync.

La chaîne d'acquisition 32 comprend :

- un amplificateur 35 programmable recevant le signal de mesure analogique S fourni par le transducteur électroacoustique 60 et fournissant un signal de mesure analogique amplifié $S_{amp}$ sensiblement égal au signal de mesure S multiplié par un gain d'amplification G ; et
- un module de traitement 36 recevant le signal de mesure amplifié fourni par l'amplificateur 35.

Le dispositif de commande et d'acquisition 30 comprend en outre :

- un microcontrôleur 37 relié à l'amplificateur 35, au module de traitement 36, au module de commande 34, et au générateur 33 ;
- un ordinateur 38 relié au microcontrôleur 37 ; et
- une interface homme-machine 39 reliée au microcontrôleur 37 et/ou à l'ordinateur 38 et comprenant notamment un écran d'affichage.

A titre de variante, le module de commande 34 et/ou le module de traitement 36 peuvent être intégrés au microcontrôleur 37.

Le dispositif de commande et d'acquisition 30 illustré en figure 8 est configuré pour la génération d'une impulsion de courant dans le fil conducteur 50 d'intensité I et de durée $\Delta t$ et se produisant éventuellement après l'écoulement d'un délai T suivant une impulsion du signal de synchronisation Sync dans le cas d'une mesure synchrone.

L'ordinateur 38 est configuré pour échanger des signaux avec le microcontrôleur 37, par exemple via un port UART (sigle anglais pour Universal asynchronous receiver-transmitter), notamment les valeurs du délai T, de la durée $\Delta t$, de l'intensité I, et la valeur du gain G de l'amplificateur programmable 35.

Selon un mode de réalisation, la valeur du gain G de l'amplificateur programmable 35 est déterminée à partir de l'amplitude $B_z$ du champ magnétique déterminée au cours de la mesure précédente. Plus l'amplitude $B_z$ déterminée lors de la mesure précédente est faible, plus la valeur du gain G est grande, par exemple selon des paliers correspondant à des plages de mesure de l'amplitude $B_z$.

Selon un mode de réalisation, le déclenchement du processus de mesure se produit à partir du signal synchronisation Sync si la mesure est synchrone. Selon un autre mode de réalisation, le déclenchement du processus de mesure se produit de façon automatique et périodique avec une période de mesure définie par l'utilisateur si la mesure est asynchrone. Dans ce cas, la période de mesure est de préférence supérieure au temps d'amortissement de l'impulsion acoustique se propageant dans le guide fuselé 40 dû à l'impulsion de courant précédente.

Selon un mode de réalisation, le générateur 33 applique une impulsion de courant d'intensité I dans le fil conducteur 50 couplé à la pointe 42 du guide fuselé 40 avec un délai T et une durée $\Delta t$ définies dans le module de commande 34. En présence du champ magnétique B, une onde acoustique ultrasonore, dont l'amplitude crête est proportionnelle à la composante $B_z$, remonte de la pointe 42 vers la base 41 du guide fuselé 40. L'onde acoustique est convertie en signal électrique de mesure S par le transducteur acoustique 60 couplé à la base 41, et le signal électrique de mesure S est amplifié par l'amplificateur programmable 35 pour fournir le signal de mesure amplifié $S_{amp}$.

Selon un mode de réalisation, le module de traitement 36 est configuré pour détecter l'amplitude de crête du signal de mesure amplifié $S_{amp}$ et fournir une valeur analogique de l'amplitude crête détectée au microcontrôleur 37. Selon un mode de réalisation, le module de traitement 36 est en outre configuré pour déterminer une valeur binaire Polar I/O représentative du signe positif ou négatif de la première impulsion du signal de mesure amplifié $S_{amp}$. En effet, la phase de l'onde acoustique change de 180° selon que la polarisation de la composante $B_z$ est orientée dans un sens ou le sens opposé. Le microcontrôleur 37 peut en outre comprendre un convertisseur analogique/numérique adapté à recevoir la valeur analogique de l'amplitude crête détectée et fournir un signal numérique de l'amplitude crête.

Selon un mode de réalisation, le microcontrôleur 37 est configuré pour recevoir directement le signal de mesure amplifié $S_{amp}$ et réaliser un échantillonnage du signal de mesure amplifié $S_{amp}$, par exemple sur une profondeur de 10 à 16 bits et à une cadence de 5 à 12 méga échantillons par seconde sur une fenêtre temporelle de 1 $\mu s$ à 100 $\mu s$. Selon un mode de réalisation, le microcontrôleur 37 est configuré pour réaliser une interpolation des points de mesure de façon à reconstituer finement le signal de mesure amplifié et obtenir une valeur précise de l'amplitude crête et de la phase du signal de mesure amplifié.

Selon un autre mode de réalisation, le microcontrôleur 37 est configuré pour déterminer la transformée de Fourier du signal de mesure amplifié $S_{amp}$. De préférence, la transformée de Fourier est déterminée à partir de la trace temporelle du signal de mesure amplifiée $S_{amp}$ incluant les pics du signal de mesure amplifié $S_{amp}$ et en excluant le couplage parasite de l'impulsion de courant ou de tension de sorte qu'il ne reste dans la trace temporelle que les pics dus à la réception du paquet d'ondes acoustiques par le transducteur 60 avec un signal de mesure nul avant son arrivée et après son arrivée.

Selon un mode de réalisation, le signal de mesure amplifié $S_{amp}$ est traité de façon à ce que ses valeurs soient nulles après le quatrième ou cinquième passage à zéro du signal de mesure amplifié $S_{amp}$, ce qui correspond au moment où l'essentiel du paquet d'ondes acoustiques a été reçu par le transducteur 60 et que l'on entre dans la queue du paquet d'ondes acoustiques. La raie spectrale d'amplitude maximale du spectre obtenu correspond à la fréquence centrale du paquet d'ondes acoustiques. L'amplitude de la raie spectrale est représentative de la valeur d'amplitude maximale du signal de mesure amplifié $S_{amp}$.

La détermination de l'amplitude crête du signal de mesure amplifié $S_{amp}$ à partir de la transformée de Fourier du signal de mesure amplifié $S_{amp}$ plutôt que directement à partir du signal de mesure amplifié $S_{amp}$ est plus précise et plus indépendante du bruit analogique existant au niveau du signal de mesure amplifié $S_{amp}$. Ceci permet d'accéder à des champs magnétiques faibles proches du champ magnétique terrestre. Dans ces cas extrêmes, la sensibilité est augmentée en remplaçant l'impulsion de courant par un train d'impulsions, comprenant par exemple 2 à 10 impulsions et préférentiellement 4 impulsions de courant équidistantes, avec une porteuse centrée sur la fréquence centrale du transducteur électromécanique 60. En outre, de façon avantageuse, la transformée de Fourier du signal de mesure amplifié $S_{amp}$ est indépendante de la durée de propagation des ondes acoustiques dans le guide fuselé 40. L'effet d'un changement de température du guide fuselé 40 se résume alors à une avance ou un retard d'arrivée du paquet d'ondes acoustiques au transducteur 60, soit simplement un changement de phase dans l'espace de Fourrier.

Le microcontrôleur 37 est configuré pour déterminer la valeur du champ $B_z$ en multipliant la valeur crête par un coefficient d'étalonnage. La valeur du champ magnétique $B_z$ et sa polarisation (nord, sud) sont affichées sur l'afficheur 39 dans une unité de mesure choisie ou transmise à l'ordinateur 38 pour un traitement complémentaire.

Selon un mode de réalisation, le dispositif de commande et d'acquisition 30 peut piloter une, deux, ou plus de deux sondes 20 à partir du même signal de synchronisation Sync, chacune des sondes 20 pouvant être excitée avec un délai T identique ou différent par rapport aux autres sondes 20 de sorte que l'on peut multiplier l'échantillonnage spatial et temporel par le nombre de sondes 20 utilisées. Si plusieurs sondes 20 sont excitées avec des délais T légèrement différents et disposées pratiquement au même endroit d'une source magnétique relativement étendue spatialement mais oscillant très rapidement, on peut multiplier le nombre de points d'échantillonnage du champ magnétique par le nombre de sondes 20 utilisées.

La figure 9 représente un schéma par blocs du système de détection 10 illustrant un mode de réalisation du dispositif de commande et d'acquisition 30 pour la mise en oeuvre du mode de fonctionnement réciproque. Le dispositif de commande et d'acquisition 30 représenté en figure 9 comprend les mêmes éléments que le dispositif de commande et d'acquisition 30 représenté en figure 8 à la différence que le signal de mesure $S_{amp}$ reçu par l'amplificateur 35 correspond à la tension aux bornes du fil conducteur 50 et que le générateur 33 d'impulsions de courant est remplacé par un générateur 33 d'impulsions de tension fournies au transducteur 60.

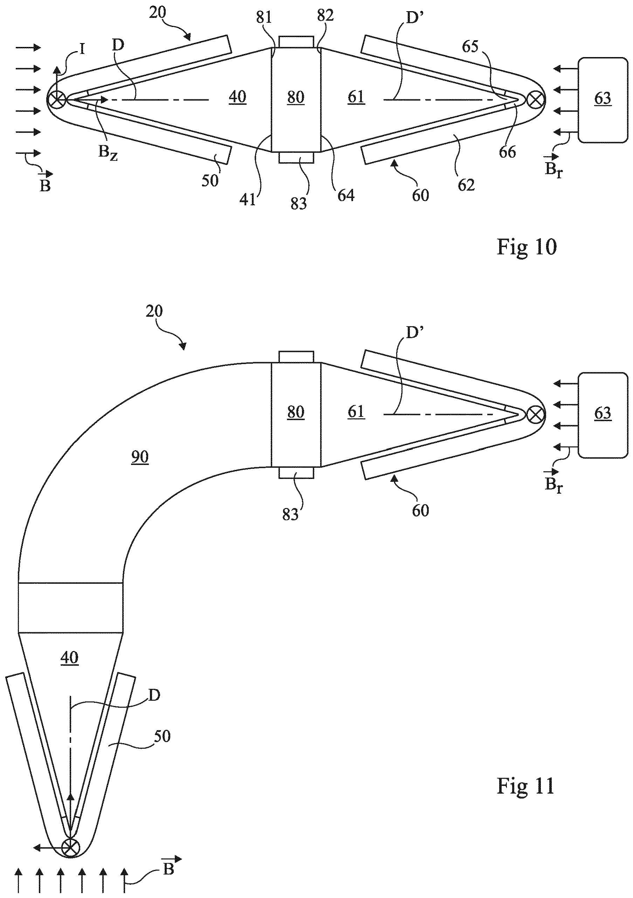

La figure 10 est une vue en coupe, partielle et schématique, d'un mode de réalisation du transducteur électroacoustique 60 de la sonde 20. En figure 10, le transducteur électroacoustique 60 est un transducteur électroacoustique à ondes transversales comprenant un guide d'ondes acoustiques 61, un fil conducteur électriquement 62, et un aimant permanent 63.

Le guide d'ondes acoustiques 61 peut avoir la même forme que le guide fuselé 40, c'est-à-dire une forme fuselée selon un axe D' depuis une base 64 jusqu'à une extrémité 65, appelée pointe par la suite, opposée à la base 64. Le guide d'ondes acoustiques 61 est appelé guide fuselé 61 par la suite. Selon un mode de réalisation, le guide fuselé 61 a une forme générale d'un cône de révolution d'axe D', éventuellement tronqué, de faible angle au sommet. Selon un mode de réalisation, le fil conducteur 62 est replié sur la pointe 65 du guide fuselé 61 et est fixé à la pointe 65 par un matériau de collage 66. Le fil conducteur 62 forme une demi-boucle sensiblement coplanaire avec la demi-boucle formée par le fil conducteur 50. L'aimant permanent 63 est situé à proximité de la pointe 65 du guide fuselé 61, de préférence quasiment au contact du guide fuselé 61 sans toutefois le toucher, par exemple à une distance de 100 $\mu$m pour un aimant de diamètre égal à 2 mm ou 3 mm. L'aimant permanent 63 génère un champ magnétique de référence $\overrightarrow{B_r}$ au niveau de la pointe 65 du guide fuselé 61. En figure 10, l'axe de révolution D du guide fuselé 40 et l'axe de révolution D' du guide fuselé 61 sont parallèles, de préférence confondus.

En figure 10, la sonde 20 comprend en outre le guide droit 80 comprenant deux faces opposées 81 et 82 et un élément de support 83 du guide droit 80. Dans le mode de réalisation illustré en figure 10, le guide droit 80 a une forme cylindrique à base circulaire. Selon un mode de réalisation, le guide fuselé 61, le guide droit 80 et le guide fuselé 40 sont des pièces distinctes. La base 41 du guide fuselé 40 est alors fixée à la face 81 du guide droit 80 et la base 64 du guide fuselé 61 est fixée à la face opposée 82 du guide droit 80. Selon un autre mode de réalisation, le guide fuselé 61, le guide droit 80 et le guide fuselé 40 sont fabriqués d'une même pièce. La base 41 du guide fuselé 40 est alors incluse dans la face 81 du guide droit 80 et la base 64 du guide fuselée 61 est alors incluse dans la face 82 du guide droit 80.

Le fonctionnement du transducteur électroacoustique 60 représenté en figure 10 est le suivant : lorsque l'onde ultrasonore provenant du guide fuselé 40, que ce soit dans le mode de fonctionnement direct ou réciproque, arrive à la base 64 du guide fuselé 61, elle se propage jusqu'à la pointe 65 du guide fuselé 61 en s'amplifiant au fur et à mesure qu'elle se rapproche de la pointe 65. Le mode de flexion imposé à la pointe 65 du guide fuselé 61 engendre, en présence du champ magnétique de référence $\overrightarrow{B_r}$, une force électromotrice FEM dans le fil conducteur 62. On obtient ainsi une méthode de détection à moindre coût d'une onde ultrasonore large bande quasi ponctuelle selon le même principe que la méthode de génération de l'onde ultrasonore large bande servant à la mesure du champ $B_z$.

La figure 11 est une vue en coupe, partielle et schématique, d'une variante de réalisation de la sonde 20 de la figure 10. La sonde 20 représentée en figure 11 comprend l'ensemble des éléments de la sonde 20 représentée en figure 10 et comprend, en outre, un guide d'ondes acoustiques courbe 90 interposé entre le guide fuselé 40 et le guide droit 80. Le guide d'ondes acoustiques courbe 90 a une section droite constante et s'étend selon une courbe. Le guide d'ondes acoustiques courbe 90 est appelé guide courbe 90 par la suite. A titre de variante, le guide courbe 90 est interposé entre le guide droit 80 et le guide fuselé 61. Le guide fuselé 40, le guide courbe 90, le guide droit 80, et le guide fuselé 61 peuvent être des pièces distinctes ou peuvent être fabriqués d'une même pièce. Le guide courbe 90 peut avoir une section droite circulaire.

Le guide courbe 90 permet que l'axe de révolution D du guide fuselé 40 et l'axe de révolution D' du guide fuselé 61 ne soient pas parallèles, ce qui peut faciliter le montage de la sonde 20 sur un bras de positionnement. La condition de courbure du guide courbe 90 est que le rayon de courbure soit grand devant le diamètre du guide courbe 90, typiquement au moins 3 fois plus grand, afin que la propagation des ondes ultrasonores dans le guide courbe 90 soit faiblement perturbée.

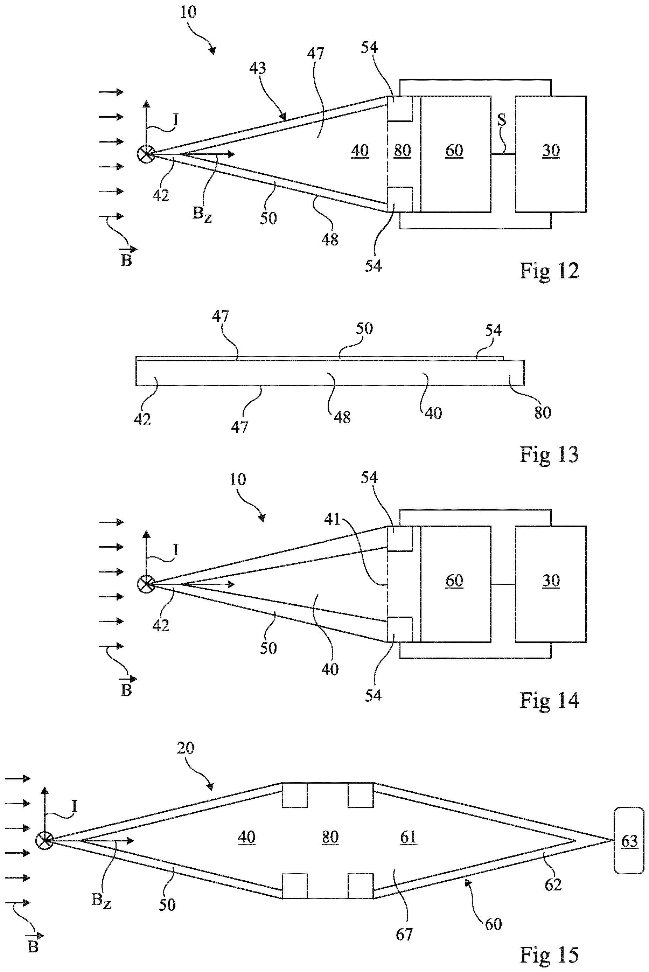

La figure 12 est une vue de dessus, partielle et schématique, d'un autre mode de réalisation du système 10 de détection d'un champ magnétique et la figure 13 est une vue de côté de la sonde 20 du système 10 de détection d'un champ magnétique de la figure 12.

Le système 10 de détection d'un champ magnétique représenté sur la figure 12 comprend l'ensemble des éléments du système 10 de détection d'un champ magnétique représenté en figure 6 dans lequel le guide fuselé 40 a la forme d'un prisme triangulaire droit et le guide droit 80 a la forme d'un parallélépipède rectangle. La paroi latérale 43 du guide fuselé 40 comprend deux faces principales 47 correspondant chacune par exemple à un triangle isocèle et des flancs 48 correspondant à des rectangles. Le guide fuselé 40 peut être dans les matériaux décrits précédemment pour le mode de réalisation illustré en figure 1. En particulier, dans le cas où le guide fuselé 40 est en un matériau conducteur, un couche isolante, non représentée, peut être interposée entre le guide fuselé 40 et la piste conductrice 50. Le guide fuselé 40 peut être réalisé sur une plaquette en verre ou en un matériau semiconducteur, par exemple en silicium, d'épaisseur de l'ordre de 100 $\mu$m et préférentiellement moins de 1000 $\mu$m avec les techniques de photogravure. Dans le présent mode de réalisation, le fil conducteur 50 correspond à une piste conductrice déposée sur une face principale triangulaire 47 du guide fuselé 40, par exemple par pulvérisation cathodique ou croissance électrochimique. Les connexions électriques se font aux moyens de fils de connexion fixés à des plots conducteurs 54 situés par exemple sur le guide droit 80. La piste conductrice 50 peut avoir une largeur de l'ordre du micromètre à la pointe 42 du guide fuselé 40. Comme cela est représenté en figure 12, la piste conductrice 50 a une largeur sensiblement constante.

Lorsque le guide fuselé 40 correspond à un prisme, le mode de flexion dans le guide d'onde fuselé 40 qui apparaît en fonctionnement correspond plus précisément au premier mode antisymétrique de Lamb $A_0$.

La figure 14 est une vue de dessus, partielle et schématique, d'une variante de la sonde 20 dans laquelle la piste conductrice 50 a une largeur qui croît depuis la pointe 42 jusqu'à la base 41 du guide fuselé 40. Ceci permet de réduire la résistance ohmique de la piste conductrice 50.

Selon un mode de réalisation, la face triangulaire 47 du guide fuselé 40 est recouverte partiellement d'une couche conductrice électriquement réalisant un blindage électrique.

La figure 15 est une vue de dessus, partielle et schématique, d'une variante de réalisation de la sonde 20 et du transducteur électroacoustique 60 du système 10 de détection d'un champ magnétique illustré en figure 12. La sonde 20 et le transducteur électroacoustique 60 représentés en figure 15 comprennent l'ensemble des éléments de la sonde 20 et du transducteur électroacoustique 60 représentés en figure 10 à la différence que le guide fuselé 40, le guide droit 80, et le guide fuselé 61 du transducteur électroacoustique 60 ont chacun la forme d'un prisme. Plus précisément, le guide fuselé 40 a la structure décrite précédemment en relation avec les figures 12 et 13. Le transducteur électroacoustique 60 est un transducteur électroacoustique à ondes transversales comprenant un guide prismatique 61 ayant la même forme que le guide fuselé 40. En outre, le fil conducteur 62 correspond à une piste conductrice déposée sur une face triangulaire 67 du guide fuselé 61, par exemple par pulvérisation cathodique ou croissance électrochimique. Le guide fuselé 40, le guide droit 80, et le guide fuselé 61 peuvent être fabriqués d'une même pièce par découpe d'une plaquette.

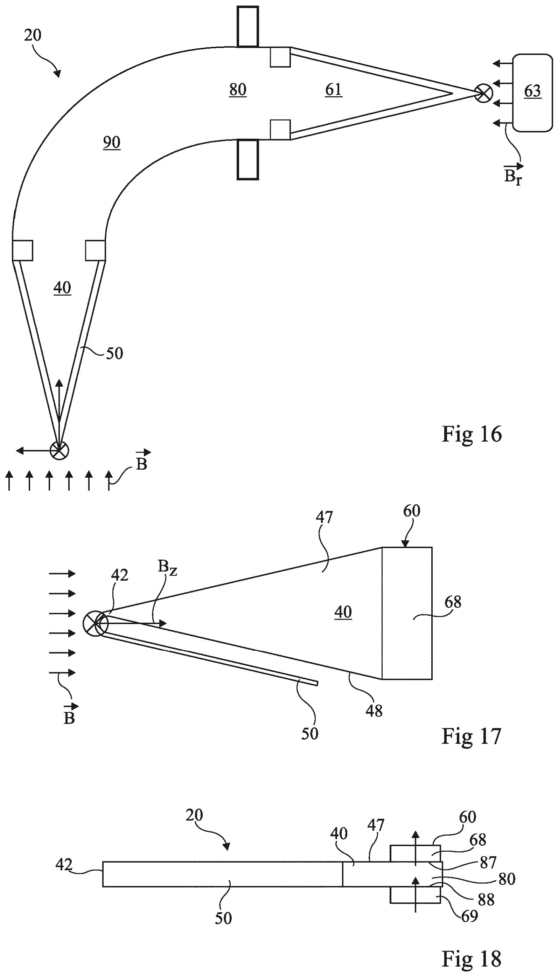

La figure 16 est une vue en coupe, partielle et schématique, d'une variante de réalisation de la sonde 20 et du transducteur électroacoustique 60 du système 10 de détection d'un champ magnétique illustré en figure 15. La sonde 20 et le transducteur électroacoustique 60 représentés en figure 16 comprennent l'ensemble des éléments de la sonde 20 et du transducteur électroacoustique 60 représentés en figure 11 à la différence que le guide fuselé 40, le guide courbe 90, le guide droit 80, et le guide fuselés 61 du transducteur électroacoustique 60 ont des structures prismatiques. Le guide fuselé 40, le guide courbe 90, le guide droit 80, et le guide fuselé 61 peuvent être fabriqués d'une même pièce par découpe d'une plaquette.

La figure 17 est une vue de dessus, partielle et schématique, d'un autre mode de réalisation de la sonde 20 et la figure 18 est une vue de côté de la sonde 20 de la figure 17.

La sonde 20 comprend l'ensemble des éléments de la sonde 20 représentée en figure 12 à la différence que le guide fuselé 40 est en un matériau conducteur électriquement, par exemple en métal, et que le fil conducteur 50 correspond à une lame conductrice électriquement s'étendant le long d'un flanc 48 du guide fuselé 40 depuis la pointe 42 du guide fuselé 40, à distance du flanc 48 du guide fuselé 40, et qui est connectée au guide fuselé 40 à la pointe 42 du guide fuselé 40. Selon un mode de réalisation, le guide fuselé 40, et le fil conducteur 50 sont fabriqués d'une même pièce par découpe d'une plaquette métallique. Ceci permet de faciliter le montage/positionnement fin du fil conducteur 50 à la pointe 42 du guide fuselé 40. En particulier, le rayon et la forme du fil conducteur 50 au niveau de la pointe 42 du guide fuselé 40 peuvent être adaptés de façon à optimiser la force de Lorentz sur un segment de matière orienté perpendiculairement à la composante axiale $B_z$. Selon un mode de réalisation, le fil conducteur 50 est agencé en forme de "U" au niveau de la pointe 42 du guide fuselé 40.

Selon un mode de réalisation, le transducteur électroacoustique 60 comprend des première et deuxième plaquettes piézoélectriques 68, 69 fixées au centre du guide droit 80 de la sonde 20, par exemple par collage ou par brasage, la première plaquette piézoélectrique 68 étant fixée sur une face 87 du guide droit 80, coplanaire avec la face triangulaire 47 du guide fuselé 40 et la deuxième plaquette piézoélectrique 69 étant fixée sur la face 88 du guide droit 80 opposée à la face 87.

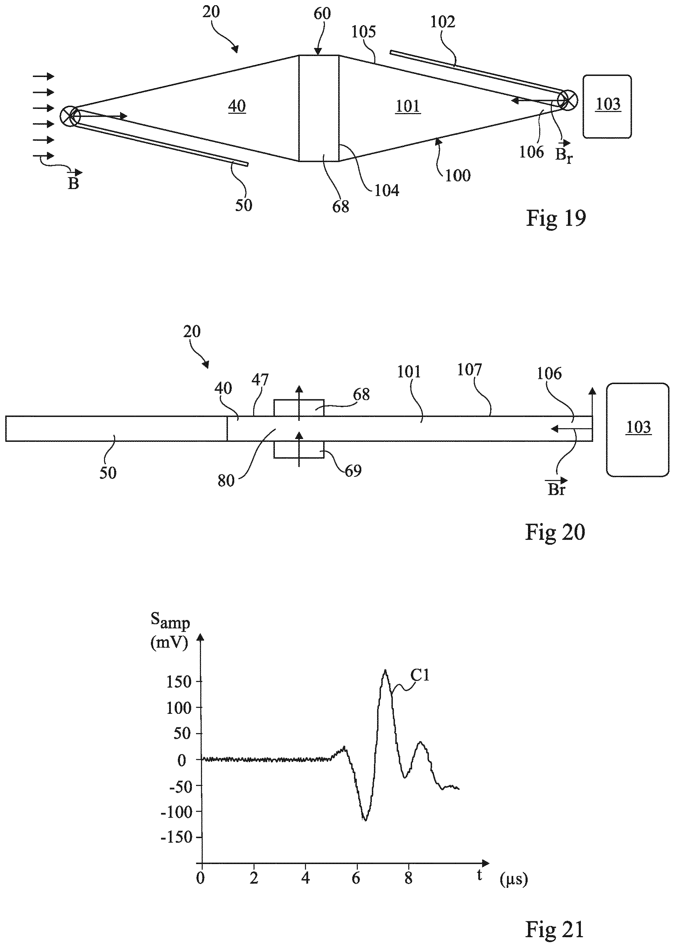

La figure 19 est une vue de dessus, partielle et schématique, d'un autre mode de réalisation de la sonde 20 et la figure 20 est une vue de côté de la sonde 20 de la figure 19.

La sonde 20 représentée en figure 19 comprend l'ensemble des éléments de la sonde 20 représentée en figure 17 et comprend en outre un dispositif d'étalonnage 100 comprenant un guide d'ondes acoustiques 101, un fil conducteur 102, et un aimant permanent 103 émettant un champ magnétique de référence $\overrightarrow{B_r}$. Le guide d'ondes acoustiques 101 comprend une base 104 qui est connectée au guide fuselé 40 par l'intermédiaire du guide droit 80. Le guide d'ondes acoustiques 101 peut avoir la même structure que le guide fuselé 40 et est appelé guide fuselé 101 par la suite. Le fil conducteur 102 peut avoir la même structure que le fil conducteur 50. Ceci signifie que le guide fuselé 101 est en un matériau conducteur électriquement, par exemple en métal, et que le fil conducteur 102 correspond à une lame conductrice électriquement s'étendant le long d'un flanc 105 du guide fuselé 101 depuis la pointe 106 du guide fuselé 101, à distance du flanc 105 du guide fuselé 101, et qui est connectée au guide fuselé 101 à la pointe 106 du guide fuselé 101.

Le guide fuselé 40, le fil conducteur 50, le guide droit 80, le guide fuselé 101, et le fil conducteur 102 sont en un matériau conducteur électriquement, par exemple en métal. Selon un mode de réalisation, le guide fuselé 40, le fil conducteur 50, le guide droit 80, le guide fuselé 101, et le fil conducteur 102 sont fabriqués d'une même pièce par découpe ou gravure chimique d'une plaquette métallique.

Selon un mode de réalisation, la sonde 20 représentée sur les figures 19 et 20 forme une sonde biconique auto étalonnée. Selon un mode de réalisation, la sonde 20 fonctionne dans le mode de fonctionnement réciproque décrit précédemment. Des signaux ultrasonores sont fournis en même temps par les plaquettes piézoélectriques 68 et 69. Selon un mode de réalisation, les plaquettes piézoélectriques 68 et 69 sont des plaquettes ferroélectriques de polarisation P d'axe perpendiculaire à la face 47. Elles sont montées en vis-à-vis et vibrent en opposition de phase lorsqu'elles sont soumises à une impulsion électrique, par exemple entre 50 V et 500 V et de préférence environ 100 V. Ceci engendre un mode de Lamb antisymétrique A0 partant depuis le centre de la sonde 20 à la fois en direction de la pointe 42 du guide fuselé 40 et en direction de la pointe 104 du guide fuselé 101.

Le guide fuselé 101 associé au champ de référence $\overrightarrow{B_r}$ connu permet de déterminer automatiquement le champ à mesurer $B_z$ qui lui est proportionnel avec une composante de proportionnalité directement dépendante du rapport entre l'amplitude crête $A_{cm}$ du signal ultrasonore de mesure et l'amplitude crête $A_{cr}$ du signal ultrasonore de référence. La pointe 42 du guide fuselé 40 vibre avec une amplitude crête perpendiculaire à la face 47 du guide fuselé 40. Ceci engendre en présence du champ magnétique $B_z$ la force électromotrice de mesure $FEM_m$. La pointe 106 du guide fuselé 101 vibre avec une amplitude crête perpendiculaire à la face principale 107 du guide fuselé 101. Ceci engendre en présence du champ Br la force électromotrice de référence $FEM_r$.

Le champ magnétique $B_z$ à mesurer est obtenu par la relation suivante :

[Math 2]

$$B_z = K \frac{A_{cm}}{A_{cr}} B_r$$

où K est un facteur de correction.

La détermination du rapport des amplitudes crêtes $A_{cm}$ et $A_{cr}$ peut être effectuée directement à partir de la détermination de chaque amplitude crête $A_{cm}$ et $A_{cr}$. A titre de variante, les transformées de Fourier des signaux de mesure et de référence échantillonnés peuvent être déterminées et le rapport des amplitudes crêtes $A_{cm}$ et $A_{cr}$ peut être obtenu en déterminant le rapport des amplitudes des composantes spectrales des spectres des signaux de mesure et de référence à une fréquence correspondant au cas où la largeur des plaquettes piézoélectriques 68 et 69 est égale à la demi-longueur d'onde du mode de Lamb A0.

L'intensité du champ magnétique de référence $\overrightarrow{B_r}$, émis par l'aimant permanent 63 peut varier de 10 mT à 500 mT. Selon un mode de réalisation, chaque guide fuselé 40 et 101 et le guide droit 80 a une épaisseur de 0,05 mm à 0,5 mm, de préférence de 0,05 mm à 0,3 mm, par exemple environ 0,2 mm. Selon un mode de réalisation, chaque guide fuselé 40 et 101 a un angle au sommet inférieur à 5 ° et la base de la face triangulaire 47, 67 a une largeur inférieure à 1 mm. A titre d'exemple, la sonde biconique 20 peut avoir une épaisseur égale à 0,1 mm, une longueur totale, mesurée de la pointe 42 du guide fuselé 40 à la pointe 104 du guide fuselé 101, égale à 20 mm, une largeur égale à 1 mm, chaque guide triangulaire fuselé 40 et 101 ayant une hauteur environ 9,5 mm et chaque fil conducteur 50 et 102 ayant une largeur égale à 100 $\mu$m et

une épaisseur égale à 100 $\mu$m.

Selon un mode de réalisation, la fréquence de travail se situe entre 500 kHz et 10 MHz et préférentiellement à une fréquence correspondant au cas où le produit de la fréquence par l'épaisseur de chaque guide fuselé 40 et 101 est voisin de 1 MHz.mm. A titre d'exemple, pour des guides fuselés 40 et 101 ayant chacun une épaisseur égale à 0,1 mm, la fréquence de travail peut être proche de 10 MHz.

Selon un mode de réalisation, il peut être déterminé que le guide fuselé 40 n'est pas endommagé à partir du contrôle de l'écho de pointe remontant du guide fuselé 40 jusqu'au guide fuselé 101. Si le guide fuselé 40 est endommagé, le signal sera modifié. Il suffit de contrôler l'amplitude de l'écho provenant du guide fuselé 40 avec un retard égal au temps de transit total d'une extrémité à l'autre de la sonde 20.

Selon un autre mode de réalisation, chaque guide fuselé 40 et 101 et le guide droit 80 peuvent être en un matériau isolant, et, par exemple, fabriqués par gravure dans une plaque isolante. Dans ce cas, les fils conducteurs 50 et 102 peuvent être réalisés par dépôt d'une encre ou pâte conductrice sur les flancs du guide fuselé 40 et 101.

Selon un mode de réalisation, deux sondes 20 peuvent être agencées selon un montage biaxial orientées à 90° l'une de l'autre, ou trois sondes 20 peuvent être agencées selon un montage triaxial orientées à 90° les unes des autres, les sondes étant réunies au niveau des pointes. Ceci permet de réaliser localement la détermination des composantes vectorielle 2D ou 3D du champ magnétique à mesurer.

Selon un mode de réalisation, le guide fuselé 40 et le guide fuselé 101 ont les mêmes dimensions de sorte que les signaux de mesure relatifs aux paquets d'ondes reçus depuis le fil conducteur 50 et le fil conducteur 102 sont identiques lorsque le champ magnétique de référence Br est égal à la composante $B_z$ à mesurer. En cas d'écart supérieur à une certaine tolérance, par exemple 3 %, on peut ajuster un facteur K de correction, voisin de l'unité et traduisant une différence de performance entre le guide fuselé 40 et le guide fuselé 101.

Selon un mode de réalisation, le système 10 de détection d'un champ magnétique est utilisé comme une tête de lecture de surfaces aimantées. L'aimant permanent 63 fournissant le champ magnétique de référence Br peut devenir très petit et encapsulé dans une enceinte de confinement des lignes de champ Br. La valeur de Br peut être inférieure ou supérieure à l'amplitude maximale envisageable du champ à mesurer $B_z$. Elle a néanmoins une valeur suffisante pour que le rapport signal/bruit permette une mesure du champ de référence Br reproductible à mieux que 1 % d'une mesure à l'autre ou une autre tolérance prédéfinie et comprise entre 0,1 % et 5 % pour le système 10.

Des exemples d'applications des modes de réalisation du système de mesure de champ magnétique décrits précédemment concernent notamment l'étude de la compatibilité électromagnétique des composants, la caractérisation de composants inductifs ou de sondes inductives de forte intensité, notamment l'étalement des lignes de champ à distance ou de fuites électromagnétiques à travers des fentes ou des ouvertures dans un blindage, ou la caractérisation de la susceptibilité magnétique des matériaux. Un autre exemple d'application est la réalisation d'une tête de lecture pour réaliser des cartographies de champs magnétiques ou lire des données stockées sous forme magnétique par détection d'une polarisation locale binaire ou d'un champ d'amplitude donnée.

Les modes de réalisation du système de mesure de champ magnétique décrits précédemment permettent d'échantillonner un champ magnétique transitoire ou oscillant, de façon synchrone, et très localisé dans l'espace et également très localisé dans le temps via une période d'échantillonnage très courte. En particulier, la résolution spatiale de mesure peut être inférieure à 0,1 mm, la durée d'échantillonnage peut être inférieure à 10 ns. Il est ainsi notamment possible de mesurer des champs magnétiques impulsionnels de durée minimale d'environ 10 ns ou des champs magnétiques variables dont la fréquence maximale est de l'ordre de 100 MHz.

Des essais ont été réalisés. Pour les premier, deuxième, troisième, quatrième, et cinquième essais, la sonde 20 a été utilisée pour mesurer le champ magnétique statique émis par un aimant permanent composé d'un alliage de néodyme, de fer et de bore. L'aimant permanent est de forme cylindrique à base circulaire de diamètre égal à 3 mm placé quasiment au contact de la pointe 42 du guide fuselé 40, l'axe de l'aimant permanent étant aligné avec l'axe D du guide fuselé 40. Pour tous les essais, le transducteur électroacoustique 60 est le transducteur piézoélectrique commercialisé par la société Olympus sous l'appellation V153 centré sur 1 MHz. Pour tous les essais, le guide fuselé 40 est en aluminium et le fil conducteur 50 est un fil en cuivre émaillé collé avec une résine cyanoacrylate à la surface d'appui 44 du guide fuselé 40. Pour tous les essais, le gain d'amplification de l'amplificateur programmable est égal à 48 dB.

Pour les premier et deuxième essais, la sonde 20 est utilisée dans le mode de fonctionnement direct et l'impulsion de courant traversant le fil conducteur 50 a une durée $\Delta$t égale à 270 ns et a une intensité I égale à 50 A.

Dans le premier essai, la sonde 20 représentée sur la figure 3 est utilisée. La hauteur du guide fuselé 40, mesurée selon son axe de révolution D, est de 82 mm et le diamètre à la base 41 est de 7 mm. Le diamètre de la surface d'appui 44 est de 0,6 mm. L'angle au sommet du guide fuselé 40 est de 4,6 °. Le fil conducteur 50 a un diamètre égal à 150 $\mu$m. Le diamètre de la surface d'appui 44 est donc égal à quatre fois le diamètre du fil conducteur 50. Le champ magnétique de l'aimant permanent a une amplitude de 445 mT.

La figure 21 représente une courbe d'évolution C1 en fonction du temps du signal de mesure amplifié $S_{amp}$ fourni par l'amplificateur 35 du système de détection 10 pour le premier essai. L'instant t0, non visible en figure 21, correspond à l'envoi du signal de synchronisation Sync pour la commande du générateur 33 d'impulsion de courant, sachant que la durée entre le front montant du signal de synchronisation Sync de l'instant d'envoi de l'impulsion de courant dans le fil conducteur 50 dure de 1 ns à 100 ns et typiquement 6 ns. L'amplitude crête est représentative du champ magnétique $B_z$ selon l'axe D du guide fuselé 40.

Dans le deuxième essai, la sonde 20 représentée sur la figure 1 est utilisée. La hauteur du guide fuselé 40, mesurée selon son axe de révolution, est de 40 mm et le diamètre à la base 41 est de 5,5 mm. L'angle au sommet du guide fuselé 40 est de 7,8 °. L'étendue latérale de la pointe 42 est d'environ 150 $\mu$m. Le fil conducteur 50 a un diamètre égal à 40 $\mu$m. Le champ magnétique de l'aimant permanent a une amplitude de 480 mT. Deux mesures sont réalisées. l'orientation de l'aimant pour la première mesure est l'inverse de l'orientation de l'aimant pour la deuxième mesure.

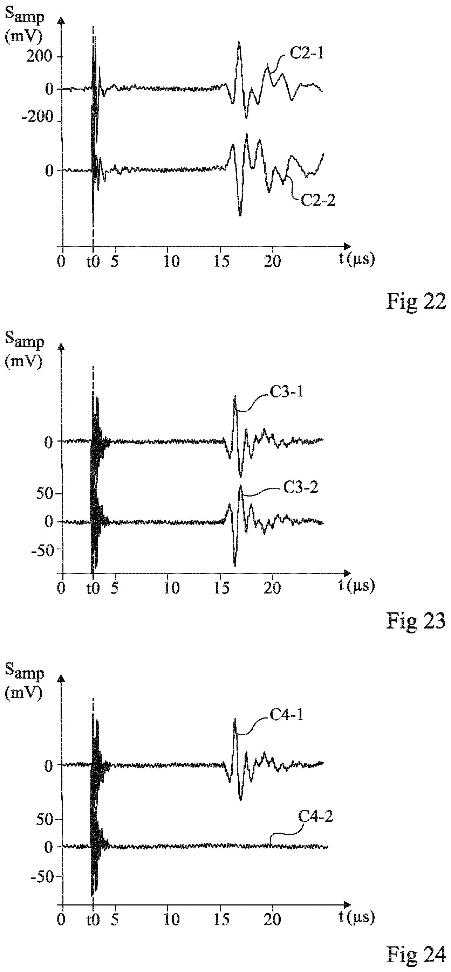

La figure 22 représente des courbes d'évolution C2_1 et C2_2 en fonction du temps du signal de mesure amplifié $S_{amp}$ fourni par l'amplificateur 35 du système de détection 10 pour le deuxième essai. L'instant t0 correspond à l'envoi du signal de synchronisation Sync pour la commande du générateur 33 d'impulsion de courant. L'orientation de l'aimant pour la courbe C2_1 est l'inverse de l'orientation de l'aimant pour la courbe C2_2. Il apparaît que selon que l'on présente le pôle nord (courbe C2_1) ou le pôle sud (courbe C2_1) de l'aimant permanent, la force magnétique de Lorentz s'inverse et la phase du signal fourni par le transducteur électroacoustique 60, de fréquence centrale égale à 769 kHz dans le deuxième essai, bascule de 180°. Le guide fuselé 40 introduit dans le deuxième essai un retard d'environ 13 $\mu$s suffisant pour bien séparer le signal de réception parasite correspondant à l'instant de l'impulsion de courant du signal de réception de l'onde ultrasonore dont l'amplitude est proportionnelle au champ magnétique $B_z$. Dans le deuxième essai, l'extrémité 42 du guide fuselé 40 étant quasi ponctuelle, la force de Lorentz s'exerce sur un volume également quasi ponctuel et il n'y a aucune résonance acoustique d'extrémité qui pourrait venir gêner la forme d'onde. La transmission de la force de Lorentz sous forme de contrainte portée par une source de faible impédance mécanique de rayonnement est alors plus efficace et le signal électrique de sortie est augmenté par rapport à la pointe tronquée du guide fuselé 40 du premier essai, par un facteur de 2,4 (400 mV crête par rapport à 170 mV crête), mais, de façon générale, ce facteur peut être supérieur à 10.

Dans les troisième et quatrième essais, la sonde 20 et l'aimant permanent du deuxième essai sont utilisés. Pour les troisième et quatrième essais, la sonde 20 est utilisée dans le mode de fonctionnement réciproque. Le transducteur électroacoustique 60 est excité par une impulsion de tension à 60 V d'une durée de 270 ns.

La figure 23 représente des courbes d'évolution C3_1 et C3_2 en fonction du temps du signal de mesure amplifié $S_{amp}$ fourni par l'amplificateur 35 du système de détection 10 pour le troisième essai. L'instant t0 correspond à l'envoi du signal de synchronisation Sync pour la commande du générateur 33 d'impulsion de courant. L'orientation de l'aimant pour la courbe C3_1 est l'inverse de l'orientation de l'aimant pour la courbe C3_2. Il apparaît que selon que l'on présente le pôle nord (courbe C3_1) ou le pôle sud (courbe C3_1) de l'aimant permanent, la force magnétique de Lorentz s'inverse et la phase de la force électromotrice dans le fil conducteur 50 bascule de 180°.

La figure 24 représente des courbes d'évolution C4_1 et C4_2 en fonction du temps du signal de mesure amplifié $S_{amp}$ fourni par l'amplificateur 35 du système de détection 10 pour le quatrième essai. La courbe C4_1 est obtenue en présence de l'aimant permanent et la courbe C4_2 est obtenue en l'absence de l'aimant permanent. En présence de l'aimant permanent, le signal de sortie atteint 100 mV crête, soit entre 3 et 4 fois moins que dans la configuration directe. La courbe C4_2 illustre qu'il n'est pas observé d'effet thermoacoustique en l'absence de champ magnétique $B_z$ dans le mode de fonctionnement réciproque.

Dans le cinquième essai, la sonde 20 et l'aimant permanent du deuxième essai sont utilisés. Pour le cinquième essai, la sonde 20 est utilisée dans le mode de fonctionnement direct.

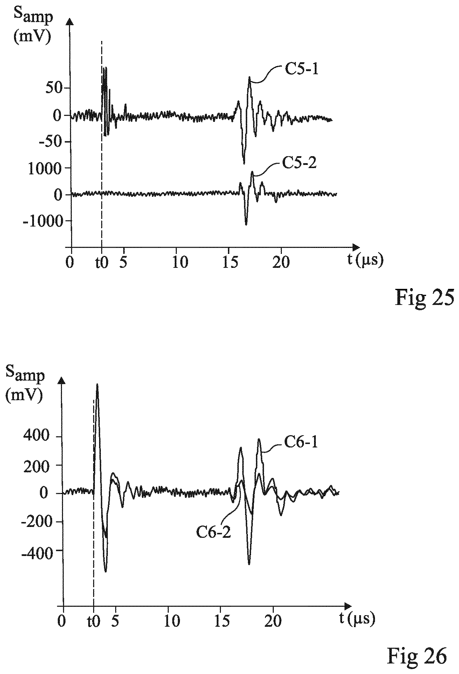

La figure 25 représente des courbes d'évolution C5_1 et C5_2 en fonction du temps du signal de mesure amplifié $S_{amp}$ fourni par l'amplificateur 35 du système de détection 10 pour le quatrième essai. La courbe C5_1 est obtenue en présence de l'aimant permanent et la courbe C5_2 est obtenue en l'absence de l'aimant permanent. Comme cela apparaît sur la figure C4_2, dans le mode de fonctionnement direct, on observe un signal thermoacoustique qui est donc caractérisé par la présence d'un signal ultrasonore même lorsque le champ magnétique $B_z$ à mesurer est nul. Toutefois, l'effet thermoacoustique atteint 80 mVc tandis que le signal magnétoacoustique en présence du champ magnétique atteint 1,2 V soit 15 fois plus que le signal thermoacoustique. Le signal thermoacoustique représente donc un bruit d'environ 32 mT. En enregistrant le signal thermoacoustique et en le soustrayant au signal de mesure, on peut réduire le bruit thermoacoustique à moins de 1 mT. On améliore ainsi la sensibilité aux champs faibles. Le bruit thermoacoustique diminue lorsque le diamètre du fil conducteur 50 augmente.

Dans le sixième essai, une première mesure est réalisée en utilisant la sonde 20 et l'aimant permanent du deuxième essai et une deuxième mesure est réalisée en utilisant la sonde 20 du deuxième essai et un électro-aimant comme source du champ magnétique $B_z$ à mesurer. L'électro-aimant comprend neuf spires d'un fil conducteur de diamètre égal à 2 mm entourant un noyau de ferrite. Pour le sixième essai, la sonde 20 est utilisée dans le mode de fonctionnement direct et l'impulsion de courant traversant le fil conducteur 50 a un durée $\Delta t$ égale à 400 ns et a une intensité I égale à 50 A. Le champ magnétique fourni par l'aimant permanent a une amplitude de 450 mT.

La figure 26 représente des courbes d'évolution C6_1 et C6_2 du signal électrique fourni par l'amplificateur 35 du système de détection 10 pour le sixième essai. La courbe C6_1 est obtenue lors d'une mesure du champ magnétique émis par l'aimant permanent. La courbe C6_2 est obtenue lors d'une mesure du champ magnétique émis par l'électro-aimant.

L'électro-aimant est commandé pendant une impulsion de durée égale à 400 ns. L'impulsion de courant dans le fil conducteur 50 est simultanée avec l'impulsion de courant dans l'électro-aimant.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. A titre d'exemple, le mode de réalisation de la sonde 20 décrit en relation avec la figure 6 comprenant des supports 83 et 84 peut être mis en oeuvre avec les modes de réalisation des guides fuselés 40 décrits en relation avec les figures 2 à 5. De même, le mode de réalisation de la sonde 20 décrit en relation avec la figure 7 comprenant une jupe 87 peut être mis en oeuvre avec les modes de réalisation des guides fuselés 40 décrits en relation avec les figures 2 à 5.

Enfin, la mise en oeuvre pratique des modes de réalisation et variantes décrits est à la portée de la personne du métier à partir des indications fonctionnelles données ci-dessus.

**Revendications**

1. Dispositif (20) de détection d'un champ magnétique ($B_z$) comprenant :

   - un premier guide d'ondes acoustiques fuselé (40) ayant une première base (41) et une première extrémité effilée (42) ;
   - un premier fil conducteur électriquement (50) rigidement couplé à la première extrémité effilée (42) ; et
   - un transducteur électroacoustique (60) rigidement couplé à la première base (41).

2. Dispositif selon la revendication 1, dans lequel le premier guide d'ondes acoustiques fuselé (40) s'étend selon un axe (D) de la première base (41) vers la première extrémité effilée (42), la section droite du premier guide d'ondes acoustiques fuselé (40) diminuant depuis la première base (41) jusqu'à la première extrémité effilée (42), et dans lequel le premier fil conducteur électriquement (50) comprend une portion (52) orthogonale audit axe (D) au niveau de la première extrémité effilée (42).

3. Dispositif selon la revendication 2, dans lequel le transducteur électroacoustique (60) est un transducteur électroacoustique à ondes transversales orienté dans le sens de ladite portion (52).

4. Dispositif selon l'une quelconque des revendications 1 à 3, dans lequel le premier guide d'ondes acoustiques fuselé (40) a la forme d'un cône ou d'un tronc de cône.

5. Dispositif selon la revendication 4, dans lequel le premier guide d'ondes acoustiques fuselé (40) a un angle au sommet inférieur à 15 °.

6. Dispositif selon la revendication 4 ou 5, dans lequel le premier guide d'ondes acoustiques fuselé (40) a la forme d'un tronc de cône, la première extrémité effilée (42) comprenant une surface plane (44).

7. Dispositif selon l'une quelconque des revendications 1 à 3, dans lequel le premier guide d'ondes acoustiques fuselé (40) a la forme d'un prisme à base triangulaire.

8. Dispositif selon l'une quelconque des revendications 1 à 7, dans lequel le transducteur électroacoustique (60) est un transducteur piézoélectrique à ondes transversales ou un transducteur électromagnétique à ondes transversales.

9. Dispositif selon l'une quelconque des revendications 1 à 8, comprenant un support (84) en un matériau isolant électriquement entourant le premier guide d'ondes acoustiques fuselé (40) à mi-chemin entre la première base (41) et la première extrémité effilée (42).

10. Dispositif selon l'une quelconque des revendications 1 à 9, comprenant une jupe (87) conductrice électriquement entourant le premier guide d'ondes acoustiques fuselé (40), à distance du guide d'ondes acoustiques fuselé (40), et comprenant une ouverture (89) pour le passage de la première extrémité effilée (42).

11. Dispositif selon l'une quelconque des revendications 1 à 10, dans lequel le transducteur électroacoustique (60) comprend un deuxième guide d'ondes acoustiques fuselé (61) comprenant une deuxième base (61) et une deuxième extrémité effilée (65), un deuxième fil conducteur électriquement (62) rigidement couplé à la deuxième extrémité effilée (65), et un premier aimant permanent (63) en face de la deuxième extrémité effilée (65).

**12.** Dispositif selon la revendication 11, dans lequel le premier guide d'ondes acoustiques fuselé (40) et le deuxième guide d'ondes acoustiques fuselé (61) forment une pièce monobloc.

**13.** Dispositif selon l'une quelconque des revendications 1 à 10, comprenant en outre un troisième guide d'ondes acoustiques fuselé (101) couplé rigidement au premier guide d'ondes acoustiques fuselé (40), le troisième guide d'ondes acoustiques fuselé (101) comprenant une troisième base (104) et une troisième extrémité effilée (106), un troisième fil conducteur électriquement (102) rigidement couplé à la troisième extrémité effilée (106), et un deuxième aimant permanent (103) en face de la troisième extrémité effilée (65), le transducteur électroacoustique (60) étant situé entre la première base (41) et la troisième base (104).

**14.** Système (10) de mesure d'un champ magnétique comprenant un dispositif (20) de détection d'un champ magnétique selon l'une quelconque des revendications 1 à 13, et un dispositif (30) de commande et d'acquisition relié au dispositif (20) de détection d'un champ magnétique comprenant un générateur (33) configuré pour fournir au moins une impulsion de courant dans le premier fil conducteur électriquement (50) et une chaîne d'acquisition pour la détection d'un signal électrique fourni par le transducteur électroacoustique (60) ou un générateur (33) configuré pour fournir au moins une impulsion de tension commandant le transducteur électroacoustique (60) et une chaîne d'acquisition pour la détection d'un signal électrique fourni par le premier fil conducteur électriquement (50).

**15.** Système selon la revendication 14, dans lequel le champ magnétique correspond à une impulsion magnétique et dans lequel le dispositif (30) de commande et d'acquisition est configuré pour que le générateur (33) fournisse une impulsion de courant dans le premier fil conducteur électriquement (50) synchrone avec l'impulsion magnétique.

**Patentansprüche**

**1.** Eine Vorrichtung (20) zum Detektieren eines Magnetfeldes ($B_z$), die Folgendes aufweist:

- einen ersten konischen akustischen Wellenleiter (40) mit einer ersten Basis (41) und einem ersten konischen Ende (42);
- einen ersten elektrisch leitenden Draht (50), der starr mit dem ersten konischen Ende (42) verbunden ist; und
- einen elektroakustischen Wandler (60), der starr mit der ersten Basis (41) verbunden ist.

**2.** Die Vorrichtung nach Anspruch 1, wobei sich der erste konische akustische Wellenleiter (40) entlang einer Achse (D) von der ersten Basis (41) zu dem ersten konischen Ende (42) erstreckt, wobei der Querschnitt des ersten konischen akustischen Wellenleiters (40) abnimmt von der ersten Basis (41) zu dem ersten konischen Ende (42), und wobei der erste elektrisch leitende Draht (50) einen Bereich (52) aufweist orthogonal zu der Achse (D) an dem ersten konischen Ende (42).

**3.** Die Vorrichtung nach Anspruch 2, wobei der elektroakustische Wandler (60) ein elektroakustischer Transversalwellen-Wandler ist, der in Richtung des genannten Bereichs (52) ausgerichtet ist.

**4.** Die Vorrichtung nach einem der Ansprüche 1 bis 3, wobei der erste konische akustische Wellenleiter (40) die Form eines Kegels oder Kegelstumpfs hat.

**5.** Die Vorrichtung nach Anspruch 4, wobei der erste konische akustische Wellenleiter (40) einen Apex-Winkel von weniger als 15° aufweist.

**6.** Die Vorrichtung nach Anspruch 4 oder 5, wobei der erste konische akustische Wellenleiter (40) wie ein Kegelstumpf geformt ist und das erste konische Ende (42) eine flache Oberfläche (44) aufweist.

**7.** Die Vorrichtung nach einem der Ansprüche 1 bis 3, wobei der erste konische akustische Wellenleiter (40) wie ein Prisma mit einer dreieckigen Basis geformt ist.

**8.** Die Vorrichtung nach einem der Ansprüche 1 bis 7, wobei der elektroakustische Wandler (60) ein piezoelektrischer Transversalwellen-Wandler oder ein elektromagnetischer Transversalwellen-Wandler ist.

**9.** Die Vorrichtung nach einem der Ansprüche 1 bis 8, aufweisend einen Träger (84) aus elektrisch isolierendem Material, der den ersten konischen akustischen Wellenleiter (40) auf halbem Weg zwischen der ersten Basis (41) und dem ersten konischen Ende (42) umgibt.

10. Die Vorrichtung nach einem der Ansprüche 1 bis 9, mit einer elektrisch leitenden Hülle (87), die den ersten konischen akustischen Wellenleiter (40) in einem Abstand von dem konischen akustischen Wellenleiter (40) umgibt und eine Öffnung (89) für den Durchgang des ersten konischen Endes (42) aufweist.

11. Die Vorrichtung nach einem der Ansprüche 1 bis 10, wobei der elektroakustische Wandler (60) einen zweiten konischen akustischen Wellenleiter (61) mit einer zweiten Basis (61) und einem zweiten konischen Ende (65), einen zweiten elektrisch leitenden Draht (62), der starr mit dem zweiten konischen Ende (65) verbunden ist, und einen ersten Permanentmagneten (63), der dem zweiten konischen Ende (65) gegenüberliegt, aufweist.

12. Die Vorrichtung nach Anspruch 11, wobei der erste konische akustische Wellenleiter (40) und der zweite konische akustische Wellenleiter (61) ein einteiliges Teil bilden.

13. Die Vorrichtung nach einem der Ansprüche 1 bis 10, ferner aufweisend einen dritten konischen akustischen Wellenleiter (101), der starr mit dem ersten konischen akustischen Wellenleiter (40) gekoppelt ist, wobei der dritte konische akustische Wellenleiter (101) eine dritte Basis (104) und ein drittes konisches Ende (106) aufweist, einen dritten elektrisch leitenden Draht (102), der starr mit dem konischen Ende (106) verbunden ist, und einen zweiten Permanentmagneten (103) gegenüber dem dritten konischen Ende (65), wobei der elektroakustische Wandler (60) zwischen der ersten Basis (41) und der dritten Basis (104) angeordnet ist.

14. Ein Magnetfeld-Messsystem (10) aufweisend eine Vorrichtung (20) zum Detektieren eines Magnetfeldes nach einem der Ansprüche 1 bis 13, und eine Steuer- und Erfassungsvorrichtung (30), die mit der Vorrichtung (20) zum Detektieren eines Magnetfelds verbunden ist, aufweisend einen Generator (33), konfiguriert zum Liefern wenigstens eines Stromimpulses in dem ersten elektrisch leitenden Draht (50), und eine Erfassungskette zum Detektieren eines elektrischen Signals, geliefert von dem elektroakustischen Wandler (60), oder einen Generator (33), konfiguriert zum Liefern wenigstens eines Spannungsimpulses, der den elektroakustischen Wandler (60) steuert, und eine Erfassungskette zum Detektieren eines elektrischen Signals, geliefert von dem ersten elektrisch leitenden Draht (50).

15. Das System nach Anspruch 14, wobei das Magnetfeld einem magnetischen Impuls entspricht, und wobei die Steuer- und Erfassungsvorrichtung (30) so konfiguriert ist, dass der Generator (33) einen Stromimpuls in der ersten elektrisch leitenden Leitung (50) synchron mit dem magnetischen Impuls liefert.

**Claims**

1. A device (20) for detecting a magnetic field ($B_2$) comprising:

   - a first tapered acoustic waveguide (40) having a first base (41) and a first tapered end (42);
   - a first electrically conductive wire (50) rigidly coupled to the first tapered end (42); and
   - an electroacoustic transducer (60) rigidly coupled to the first base (41).

2. The device according to claim 1, wherein the first tapered acoustic waveguide (40) extends along an axis (D) from the first base (41) to the first tapered end (42), the cross-section of the first tapered acoustic waveguide (40) decreasing from the first base (41) to the first tapered end (42), and wherein the first electrically conductive wire (50) comprises a portion (52) orthogonal to said axis (D) at the first tapered end (42).

3. The device according to claim 2, wherein the electroacoustic transducer (60) is a transverse-wave electroacoustic transducer oriented in the direction of said portion (52).

4. The device according to any one of claims 1 to 3, wherein the first tapered acoustic waveguide (40) is shaped like a cone or truncated cone.

5. The device according to claim 4, wherein the first tapered acoustic waveguide (40) has an apex angle of less than 15°.

6. The device according to claim 4 or 5, wherein the first tapered acoustic waveguide (40) is shaped like a truncated cone, the first tapered end (42) comprising a flat surface (44).

7.  The device according to any one of claims 1 to 3, wherein the first tapered acoustic waveguide (40) is shaped like a prism with a triangular base.

8.  The device according to any one of claims 1 to 7, wherein the electroacoustic transducer (60) is a piezoelectric transverse wave transducer or an electromagnetic transverse wave transducer.

9.  The device according to any one of claims 1 to 8, comprising a support (84) of electrically insulating material surrounding the first tapered acoustic waveguide (40) midway between the first base (41) and the first tapered end (42).

10. The device according to any one of claims 1 to 9, comprising an electrically conductive shell (87) surrounding the first tapered acoustic waveguide (40), at a distance from the tapered acoustic waveguide (40), and comprising an opening (89) for the passage of the first tapered end (42).

11. The device according to any one of claims 1 to 10, wherein the electroacoustic transducer (60) comprises a second tapered acoustic waveguide (61) comprising a second base (61) and a second tapered end (65), a second electrically conductive wire (62) rigidly coupled to the second tapered end (65), and a first permanent magnet (63) facing the second tapered end (65).

12. The device according to claim 11, wherein the first tapered acoustic waveguide (40) and the second tapered acoustic waveguide (61) form a single-piece part.

13. The device according to any one of claims 1 to 10, further comprising a third tapered acoustic waveguide (101) rigidly coupled to the first tapered acoustic waveguide (40), the third tapered acoustic waveguide (101) comprising a third base (104) and a third tapered end (106), a third electrically conductive wire (102) rigidly coupled to the third tapered end (106), and a second permanent magnet (103) opposite the third tapered end (65), the electroacoustic transducer (60) being located between the first base (41) and the third base (104).

14. A magnetic field measurement system (10) comprising a device (20) for detecting a magnetic field according to any one of claims 1 to 13, and a control and acquisition device (30) connected to the device (20) for detecting a magnetic field comprising a generator (33) configured to supply at least one current pulse in the first electrically conductive wire (50) and an acquisition chain for detecting an electrical signal supplied by the electroacoustic transducer (60) or a generator (33) configured to supply at least one voltage pulse controlling the electroacoustic transducer (60), and an acquisition chain for detecting an electrical signal supplied by the first electrically conductive wire (50).

15. The system according to claim 14, wherein the magnetic field corresponds to a magnetic pulse, and wherein the control and acquisition device (30) is configured so that the generator (33) provides a current pulse in the first electrically conductive wire (50) synchronous with the magnetic pulse.

Fig 1

Fig 2

Fig 3

Fig 4

Fig 5

Fig 6

Fig 7

Fig 8

Fig 9

Fig 10

Fig 11

Fig 12

Fig 13

Fig 14

Fig 15

Fig 16

Fig 17

Fig 18

Fig 19

Fig 20

Fig 21

Fig 22

Fig 23

Fig 24

Fig 25

Fig 26

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2210915

- US 5966008 A